# EUROPEAN PATENT APPLICATION

(11) **EP 4 583 667 A2**
(43) Date of publication of application: **09.07.2025**
(21) Application number: 24216212.1
(22) Date of filing: 28.11.2024
(51) Int. Cl.: H10D 84/01, H10D 30/01, H10D 30/00, H10D 84/83

(54) **INTEGRATED CIRCUIT DEVICE WITH NANOSHEET SEPARATION WALL**

(30) Priority: 12.12.2023 KR 20230180102
(71) Applicant: Samsung Electronics Co., Ltd., Suwon-si, Gyeonggi-do 16677 (KR)
(72) Inventor: HWANG, Donghoon, 16677 Suwon-si (KR); KIM, Hyojin, 16677 Suwon-si (KR); MOON, Byungho, 16677 Suwon-si (KR); PARK, Kyoungmi, 16677 Suwon-si (KR); PARK, Wooseok, 16677 Suwon-si (KR); YANG, Youngjin, 16677 Suwon-si (KR); JEON, Jaeho, 16677 Suwon-si (KR); HEO, Yeoncheol, 16677 Suwon-si (KR)
(74) Representative: Marks & Clerk LLP

(57) **Abstract**

An integrated circuit device includes a base substrate layer (BSUB), a sheet separation wall (LSWL, HSWL) extending in a first horizontal direction (X) on the base substrate layer, a pair of nanosheet stack structures spaced apart from each other with the sheet separation wall therebetween in a second horizontal direction (Y) different from the first horizontal direction, the pair of nanosheet stack structures each including a plurality of nanosheets, a pair of source/drain regions (SD1 or SD2) spaced apart from each other with the sheet separation wall therebetween in the second horizontal direction, wherein the pair of source/drain regions are electrically connected to the pair of nanosheet stack structures, respectively, and a pair of gate electrodes extending in the second horizontal direction on the pair of nanosheet stack structures, wherein opposing side surfaces of the sheet separation wall in the second horizontal direction include a round portion (CVP) having a convex shape between the pair of source/drain regions.

## Description

### FIELD OF THE INVENTION

The inventive concepts relate to an integrated circuit device, and more particularly, to an integrated circuit device including a multi-gate metal-oxide-semiconductor field-effect transistor (MOSFET).

### BACKGROUND

As the degree of integration of integrated circuit devices increases, a device size is reduced to a minimum state, and scaling of devices reaches a limitation. Therefore, in order to enhance the performance of devices, it may be beneficial to develop a new method based on the modification of a structure of devices, and thus, integrated circuit devices including a transistor having a new structure such as multi-gate MOSFETs have been proposed.

### SUMMARY OF THE INVENTION

One or more of the inventive concepts provide an integrated circuit device including a transistor including a multi-gate metal-oxide-semiconductor field-effect transistor (MOSFET), in which an operation characteristic is enhanced.

An integrated circuit device according to some embodiments includes a base substrate layer, a sheet separation wall extending in a first horizontal direction on the base substrate layer, a pair of nanosheet stack structures spaced apart from each other with the sheet separation wall therebetween in a second horizontal direction different from the first horizontal direction, the pair of nanosheet stack structures each including a plurality of nanosheets, a pair of source/drain regions spaced apart from each other with the sheet separation wall therebetween in the second horizontal direction, wherein the pair of source/drain regions are electrically connected to the pair of nanosheet stack structures, respectively, and a pair of gate electrodes extending in the second horizontal direction on the pair of nanosheet stack structures, wherein opposing side surfaces of the sheet separation wall in the second horizontal direction include a round portion having a convex shape between the pair of source/drain regions.

An integrated circuit device according to some embodiments includes a base substrate layer, a sheet separation wall including a lower sheet separation wall extending in a first horizontal direction on the base substrate layer and upper sheet separation walls spaced apart from one another on the lower sheet separation wall, a pair of nanosheet stack structures spaced apart from each other with the sheet separation wall therebetween in a second horizontal direction different from the first horizontal direction, the pair of nanosheet stack structures each including a plurality of nanosheets, a pair of source/drain regions spaced apart from each other with the sheet separation wall therebetween in the second horizontal direction, wherein the pair of source/drain regions are electrically connected to the pair of nanosheet stack structures, respectively, a pair of gate electrodes extending in the second horizontal direction on the pair of nanosheet stack structures, a gate capping layer on the pair of gate electrodes, a first gate insulation layer between a first one of the pair of gate electrodes and a first one of the pair of nanosheet stack structures, and a second gate insulation layer between a second one of the pair of gate electrodes and a second one of the pair of nanosheet stack structures.

An integrated circuit device according to some embodiments includes a base substrate layer, a sheet separation wall extending in a first horizontal direction and including a lower portion in the base substrate layer, a pair of nanosheet stack structures spaced apart from each other with the sheet separation wall therebetween in a second horizontal direction different from the first horizontal direction, the pair of nanosheet stack structures each including a plurality of nanosheets, a pair of source/drain regions spaced apart from each other with the sheet separation wall therebetween in the second horizontal direction, wherein the pair of source/drain regions are electrically connected to the pair of nanosheet stack structures, respectively, a pair of gate electrodes extending in the second horizontal direction on the pair of nanosheet stack structures, wherein a first one of the pair of gate electrodes extends between adjacent ones of the plurality of nanosheets included in a first one of the pair of nanosheet stack structures, and wherein a second one of the pair of gate electrodes extends between adjacent ones of the plurality of nanosheets included in a second one of the pair of nanosheet stack structures, a first gate insulation layer between the first one of the pair of gate electrodes and the first one of the pair of nanosheet stack structures, a second gate insulation layer between the second one of the pair of gate electrodes and the second one of the pair of nanosheet stack structures, a gate capping layer on the pair of gate electrodes, an interlayer insulation layer on the pair of source/drain regions, a first contact extending into the interlayer insulation layer and electrically connected to at least one of the pair of source/drain regions, and a second contact extending into the gate capping layer and electrically connected to at least one of the pair of gate electrodes, wherein the sheet separation wall includes a lower sheet separation wall extending in the first horizontal direction and upper sheet separation walls spaced apart from one another on the lower sheet separation wall, wherein opposing side surfaces of the sheet separation wall in the second horizontal direction include a round portion having a convex shape between the pair of source/drain regions, and wherein the opposing side surfaces of the sheet separation wall are planar between the pair of nanosheet stack structures.

At least some of the above and other features of the invention are set out in the claims.

### BRIEF DESCRIPTION OF THE DRAWINGS

Example embodiments will be more clearly understood from the following detailed description taken in conjunction with the accompanying drawings, in which:
FIG. 1 is a layout of an integrated circuit device according to some embodiments;
FIGS. 2A to 2D, 3A to 3D, 4A to 4D, 5A to 5D, 6A to 6D, 7A to 7D, 8A to 8D, 9A to 9D, 10A to 10D, and 11A to 11D are vertical cross-sectional views for describing a method of manufacturing an integrated circuit device, according to some embodiments;
FIGS. 12A to 12D are vertical cross-sectional views of an integrated circuit device according to some embodiments;
FIG. 13 is a vertical cross-sectional view of an integrated circuit device according to some embodiments;
FIGS. 14A and 14B are vertical cross-sectional views of an integrated circuit device according to some embodiments;
FIG. 15 is a vertical cross-sectional view of an integrated circuit device according to some embodiments; and
FIGS. 16A and 16B are vertical cross-sectional views of an integrated circuit device according to some embodiments.

### DETAILED DESCRIPTION

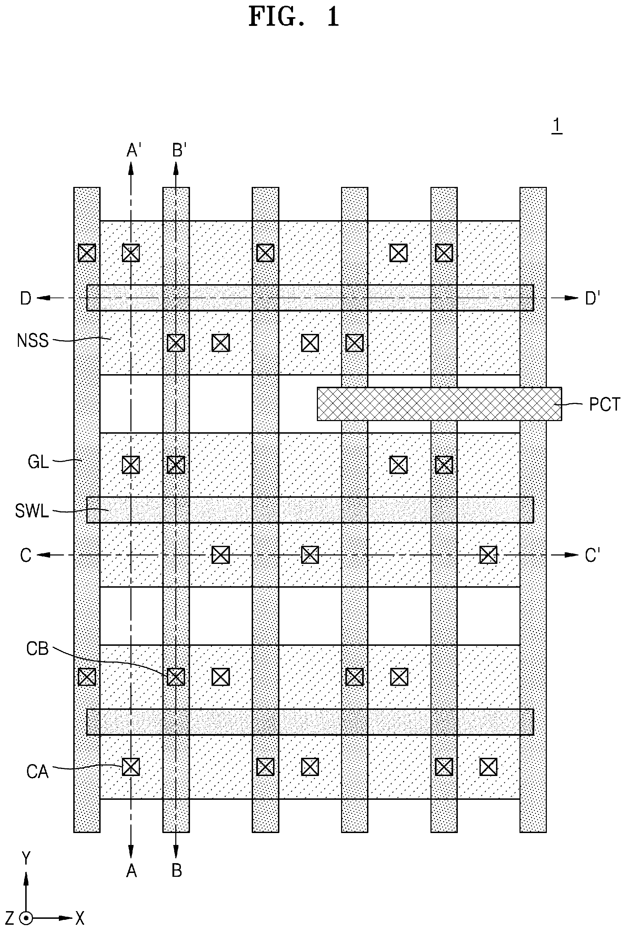

FIG. 1 is a layout of an integrated circuit device 1 according to some embodiments.

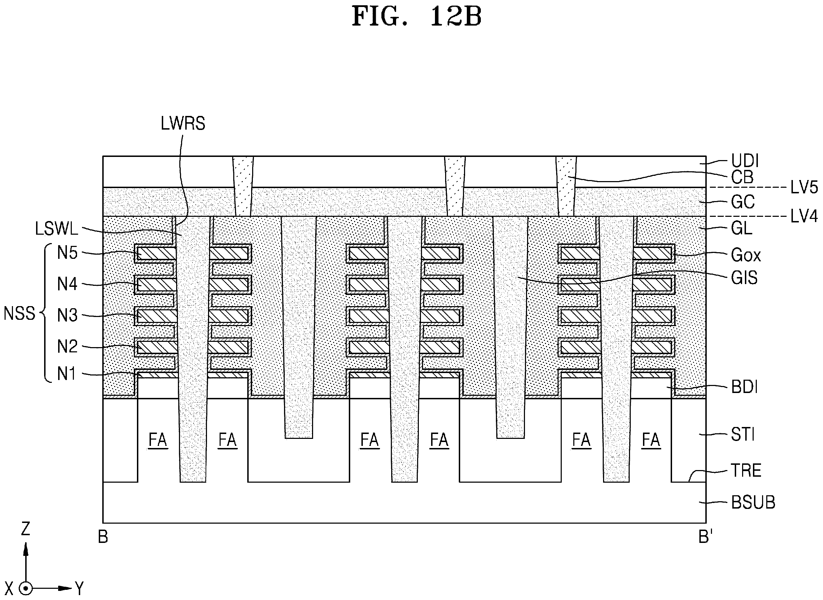

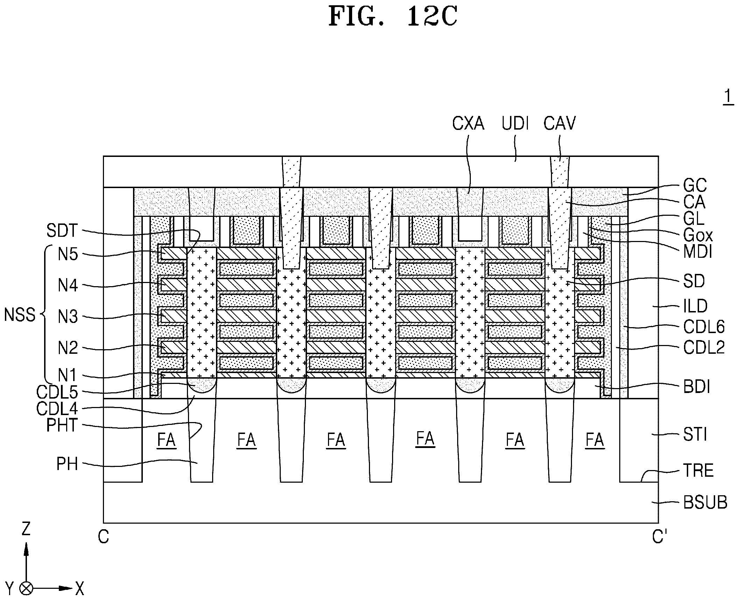

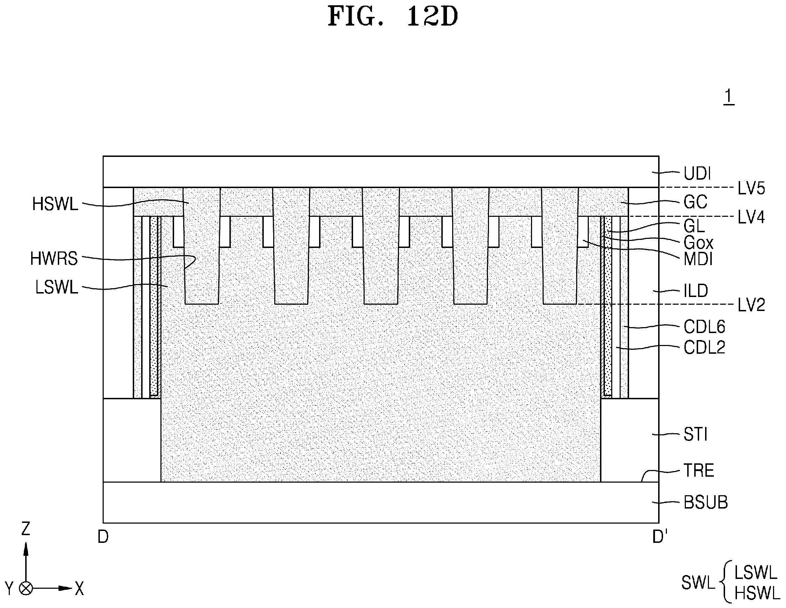

Referring to FIG. 1, the integrated circuit device 1 may include a plurality of sheet separation walls SWL extending in a first horizontal direction (an X direction), a plurality of nanosheet stack structures NSS, a plurality of gate electrodes GL extending in a second horizontal direction (a Y direction), and at least one gate cut structure PCT which extends in the first horizontal direction (the X direction) and cuts at least some of the plurality of gate electrodes GL. The first horizontal direction (the X direction) may be perpendicular to the second horizontal direction (the Y direction). The plurality of nanosheet stack structures NSS may each include a plurality of nanosheets (N1 to N5 of FIGS. 12B and 12C) which are stacked apart from one another in a vertical direction (a Z direction).

The integrated circuit device 1 may include a plurality of logic cells. Each of the logic cells may include a plurality of circuit elements such as a transistor and a resistor and may be variously configured. The logic cell may configure, for example, an AND gate, a NAND gate, an OR gate, a NOR gate, an exclusive OR (XOR) gate, an exclusive NOR (XNOR) gate, an inverter (INV), an adder (ADD), a buffer (BUF), a delay (DLY), a filter (FIL), a multiplexer (MXT/MXIT), an OR/AND/INVERTER (OAI), an AND/OR (AO) gate, an AND/OR/INVERTER (AOI), a D flip-flop, a reset flip-flop, a master-slave flip-flop, or a latch. Also, the logic cell may configure a standard cell which performs a logical function.

The plurality of nanosheet stack structures NSS may be arranged to configure rows and columns in the first horizontal direction (the X direction) and the second horizontal direction (the Y direction). The plurality of nanosheet stack structures NSS may be adjacent to the plurality of sheet separation walls SWL and may be arranged to configure columns in the first horizontal direction (the X direction). A pair of nanosheet stack structures NSS corresponding to each other among the plurality of nanosheet stack structures NSS may be disposed apart from each other in the second horizontal direction (the Y direction) with the sheet separation wall SWL therebetween.

Two gate electrodes GL divided by the gate cut structure PCT may be apart from each other in the second horizontal direction (the Y direction) with the gate cut structure PCT therebetween.

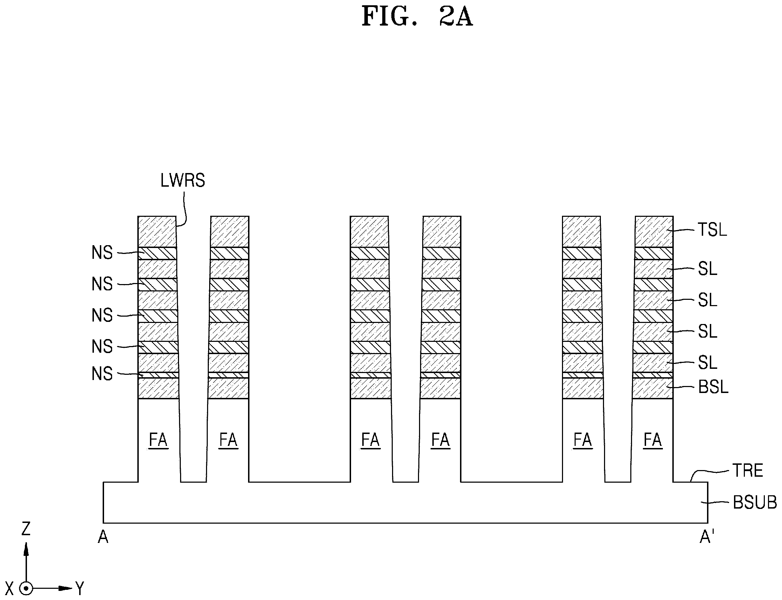

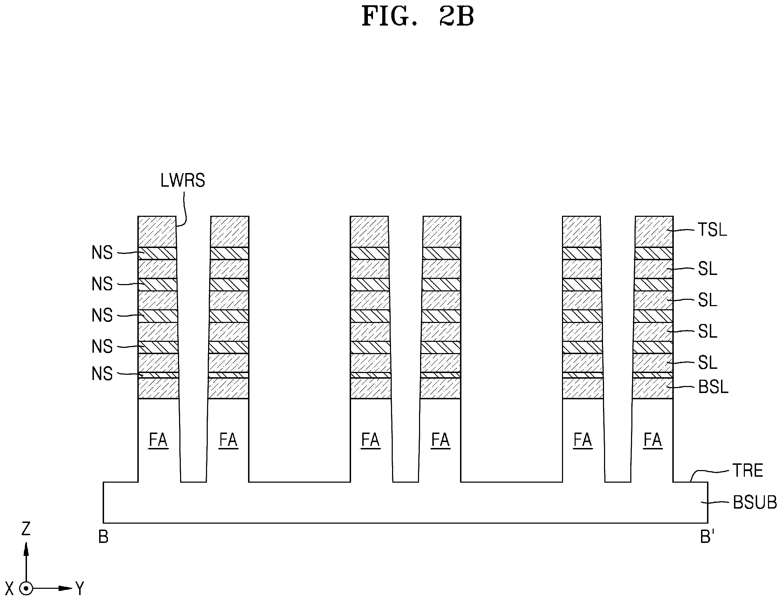

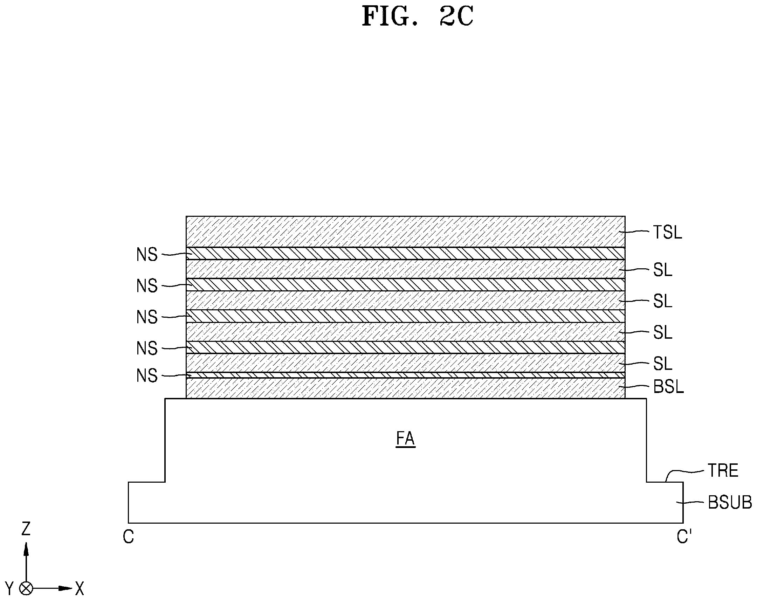

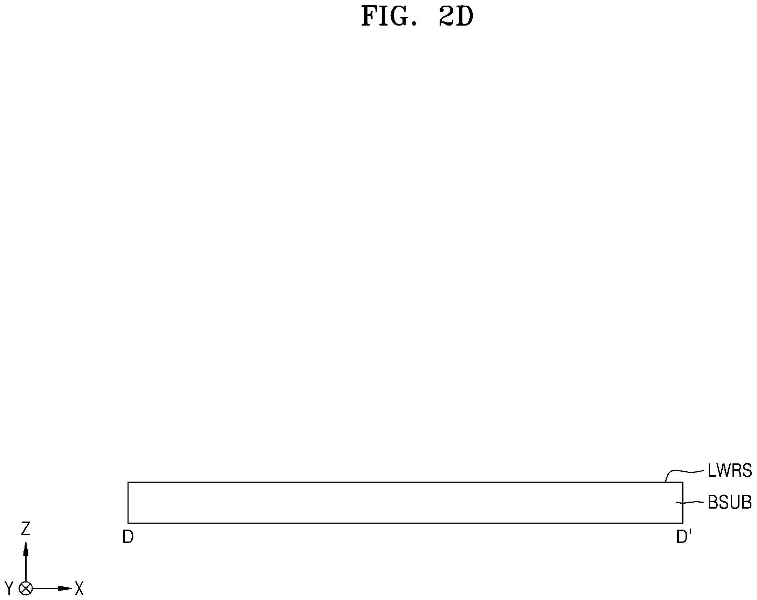

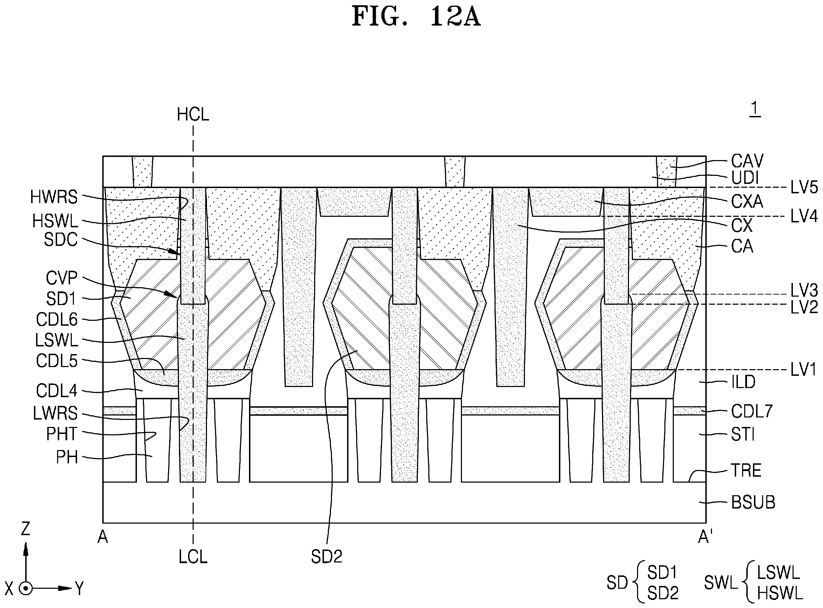

FIGS. 2A to 2D, 3A to 3D, 4A to 4D, 5A to 5D, 6A to 6D, 7A to 7D, 8A to 8D, 9A to 9D, 10A to 10D, and 11A to 11D are vertical cross-sectional views for describing a method of manufacturing an integrated circuit device, according to some embodiments, and FIGS. 12A to 12D are vertical cross-sectional views of an integrated circuit device according to some embodiments. In detail, FIGS. 2A, 3A, 4A, 5A, 6A, 7A, 8A, 9A, 10A, 11A, and 12A are vertical cross-sectional views taken along a portion corresponding to line A-A' of FIG. 1, FIGS. 2B, 3B, 4B, 5B, 6B, 7B, 8B, 9B, 10B, 11B, and 12B are vertical cross-sectional views taken along a portion corresponding to line B-B' of FIG. 1, FIGS. 2C, 3C, 4C, 5C, 6C, 7C, 8C, 9C, 10C, 11C, and 12C are vertical cross-sectional views taken along a portion corresponding to line C-C' of FIG. 1, and FIGS. 2D, 3D, 4D, 5D, 6D, 7D, 8D, 9D, 10D, 11D, and 12D are vertical cross-sectional views taken along a portion corresponding to line D-D' of FIG. 1.

Referring to FIGS. 2A to 2D, a base sacrificial layer BSL may be formed on a base substrate layer BSUB, and then, a plurality of nanosheet semiconductor layers NS and a plurality of sacrificial layers SL may be alternately stacked layer-by-layer on the base sacrificial layer BSL and a top sacrificial layer TSL may be formed on an uppermost nanosheet semiconductor layer NS of the plurality of nanosheet semiconductor layers NS. Each of the plurality of sacrificial layers SL may be disposed between two nanosheet semiconductor layers NS adjacent to each other in the vertical direction (the Z direction) among the plurality of nanosheet semiconductor layers NS. Each of the plurality of nanosheet semiconductor layers NS, the plurality of sacrificial layers SL, and the top sacrificial layer TSL may extend in parallel with an upper surface of the base substrate layer BSUB. In some embodiments, a lowermost nanosheet semiconductor layer NS of the plurality of nanosheet semiconductor layers NS may be formed to be thinner than each of the other nanosheet semiconductor layers NS. In some embodiments, the top sacrificial layer TSL may be formed to be thinner than each of the plurality of sacrificial layers SL, but is not limited thereto. For example, the first horizontal direction (the X direction) and the second horizontal direction (the Y direction) may be parallel to a bottom surface of the base substrate layer BSUB, and the vertical direction (the Z direction) may be perpendicular to the bottom surface of the base substrate layer BSUB.

The base substrate layer BSUB may include a semiconductor material, such as silicon (Si) or germanium (Ge), or a compound semiconductor such as silicon germanium (SiGe), silicon carbide (SiC), gallium arsenide (GaAs), indium arsenide (InAs), or indium phosphide (InP). In some embodiments, the base substrate layer BSUB may include at least one of Group III-V semiconductor materials and Group IV semiconductor materials. Each of the Group III-V semiconductor materials may be a binary, ternary, or quaternary compound semiconductor material including at least one Group III element and at least one Group V element. The base substrate layer BSUB may include a conductive region and, for example, may include an impurity-doped well or an impurity-doped structure.

In some embodiments, the plurality of nanosheet semiconductor layers NS may include a material having an etch characteristic which is the same as or similar to that of a material of the base substrate layer BSUB. The base sacrificial layer BSL, the plurality of sacrificial layers SL, and the top sacrificial layer TSL may include a material having an etch selectivity with respect to the plurality of nanosheet semiconductor layers NS. The base sacrificial layer BSL may include a material having an etch selectivity with respect to the plurality of sacrificial layers SL and the top sacrificial layer TSL. In some embodiments, each of the plurality of nanosheet semiconductor layers NS and the base substrate layer BSUB may include a semiconductor material such as Si or Ge. In some embodiments, the base sacrificial layer BSL, the plurality of sacrificial layers SL, and the top sacrificial layer TSL may include a compound semiconductor such as SiGe. For example, a concentration of Ge atoms among Si atoms and Ge atoms included in the base sacrificial layer BSL may be higher than a concentration of Ge atoms among Si atoms and Ge atoms included in each of the plurality of sacrificial layers SL and the top sacrificial layer TSL.

A plurality of hard mask patterns may be formed on the plurality of nanosheet semiconductor layers NS, the plurality of sacrificial layers SL, and the top sacrificial layer TSL, and then, the top sacrificial layer TSL, the plurality of nanosheet semiconductor layers NS, the plurality of sacrificial layers SL, and the base sacrificial layer BSL may be patterned by using the plurality of hard mask patterns as an etch mask, and by removing a portion of the base substrate layer BSUB exposed between patterned resultant materials and together, a plurality of trenches TRE and a plurality of lower separation recesses LWRS may be formed. The plurality of hard mask patterns may be formed to extend in the first horizontal direction (the X direction) and be apart from one another in the second horizontal direction (the Y direction). Each of the plurality of hard mask patterns may include nitride. For example, each of the plurality of hard mask patterns may include silicon nitride. After the plurality of trenches TRE and the plurality of lower separation recesses LWRS are formed, the plurality of hard mask patterns may be removed.

Each of the plurality of trenches TRE and the plurality of lower separation recesses LWRS may be formed to extend in the first horizontal direction (the X direction). In some embodiments, the plurality of trenches TRE and the plurality of lower separation recesses LWRS may be formed to be alternately arranged in the second horizontal direction (the Y direction). The plurality of trenches TRE may be formed so that a horizontal width of each of the plurality of trenches TRE is greater than a horizontal width of each of the plurality of lower separation recesses LWRS, in the second horizontal direction (the Y direction). In some embodiments, each of the plurality of trenches TRE and the plurality of lower separation recesses LWRS may be formed to have a tapered shape which increases in horizontal width and extends in the vertical direction (the Z direction). The taper may increase in width as a distance from the substrate layer BSUB increases.

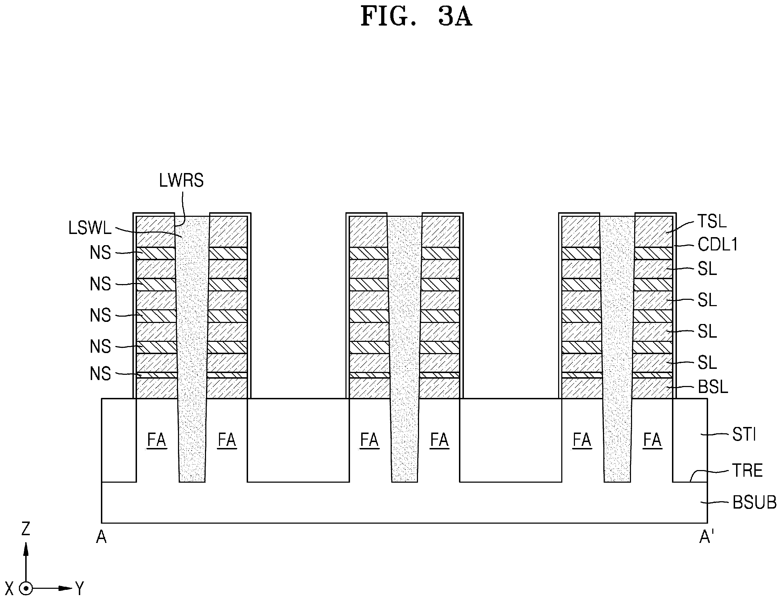

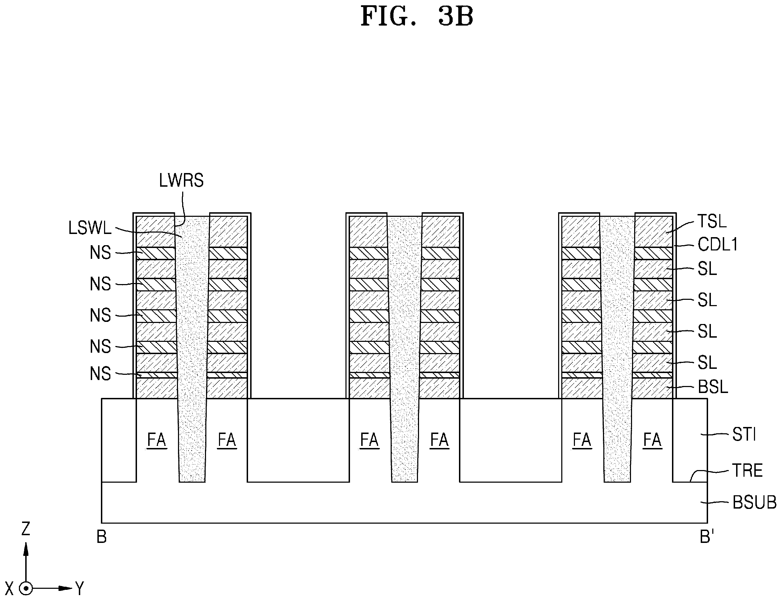

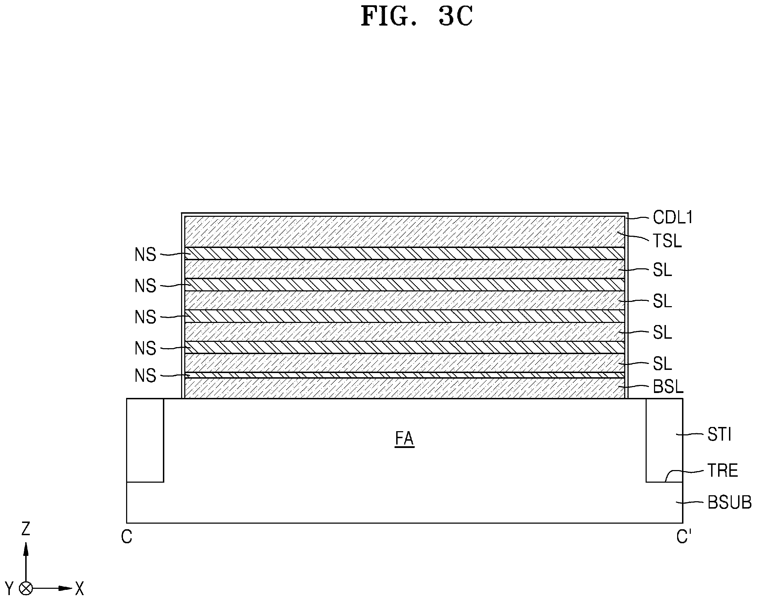

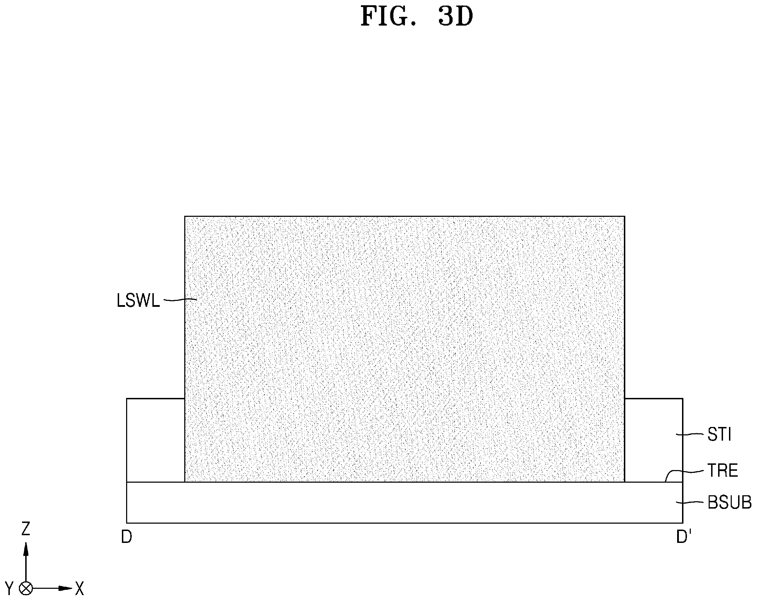

Referring to FIGS. 3A to 3D, a lower sheet separation wall LSWL filling each of the plurality of lower separation recesses LWRS and a device isolation layer STI filling each of the plurality of trenches TRE are formed, and then, a first insulation layer CDL1 on (e.g., covering) the plurality of nanosheet semiconductor layers NS, the plurality of sacrificial layers SL, and the top sacrificial layer TSL may be formed. For example, the lower sheet separation wall LSWL may include silicon nitride. The first insulation layer CDL1 may include oxide. In some embodiments, the first insulation layer CDL1 may be formed to be on (e.g., to cover) an upper surface of the device isolation layer STI and side surfaces and upper surfaces of the plurality of stack structures each including the lower sheet separation wall LSWL, the plurality of nanosheet semiconductor layers NS, the plurality of sacrificial layers SL, and the top sacrificial layer TSL.

In some embodiments, the device isolation layer STI may be formed so that an upper surface of the device isolation layer STI is at a vertical level, which is higher than or equal to an upper surface of the base substrate layer BSUB, and is at a vertical level which is lower than an upper surface of the base sacrificial layer BSL. As used herein, "vertical level" (or similar language) refers to a height in the vertical direction (the Z direction) from a bottom surface of the base substrate layer BSUB. In other words, a vertical level may be taken in the vertical direction (the Z direction), with the bottom surface of the base substrate layer BSUB providing a base reference plane. The device isolation layer STI may be formed by performing a recess process of forming a preliminary device isolation layer filling the trench TRE, and then, removing the preliminary device isolation layer by a certain thickness from an upper portion thereof. For example, the device isolation layer STI may include silicon oxide, silicon nitride, silicon oxynitride, or a combination thereof. A portion of the base substrate layer BSUB defined by the device isolation layer STI may be referred to as a fin-type active region FA. For example, the device isolation layer STI may include a material including at least one of silicon oxide, silicon nitride, or silicon oxynitride. The device isolation layer STI may include a single layer consisting of one kind of insulation layer, a double layer consisting of two kinds of insulation layers, or a multilayer consisting of a combination of at least three kinds of insulation layers. For example, the device isolation layer STI may include two kinds of different isolation layers. For example, the device isolation layer STI may include silicon oxide and silicon nitride. For example, the device isolation layer STI may include a triple layer including silicon oxide, silicon nitride, and silicon oxynitride.

In some embodiments, the first insulation layer CDL1 may be selectively formed on a semiconductor material. For example, the first insulation layer CDL1 may be formed to conformally cover surfaces of the plurality of nanosheet semiconductor layers NS, the plurality of sacrificial layers SL, and the top sacrificial layer TSL and not to cover the lower sheet separation wall LSWL and the device isolation layer STI. The first insulation layer CDL1 may be formed by oxidizing surface portions of the plurality of nanosheet semiconductor layers NS, the plurality of sacrificial layers SL, and the top sacrificial layer TSL. In some other embodiments, the first insulation layer CDL1 may be formed to conformally cover the upper surface of the device isolation layer STI and the side surfaces and the upper surfaces of the plurality of stack structures each including the lower sheet separation wall LSWL, the plurality of nanosheet semiconductor layers NS, the plurality of sacrificial layers SL, and the top sacrificial layer TSL. For example, the first insulation layer CDL1 may be formed by a thermal oxidation process, an atomic layer deposition (ALD) process, a chemical vapor deposition (CVD) process, a physical vapor deposition (PVD) process, a metal organic ALD (MOALD) process, or a metal organic CVD (MOCVD) process.

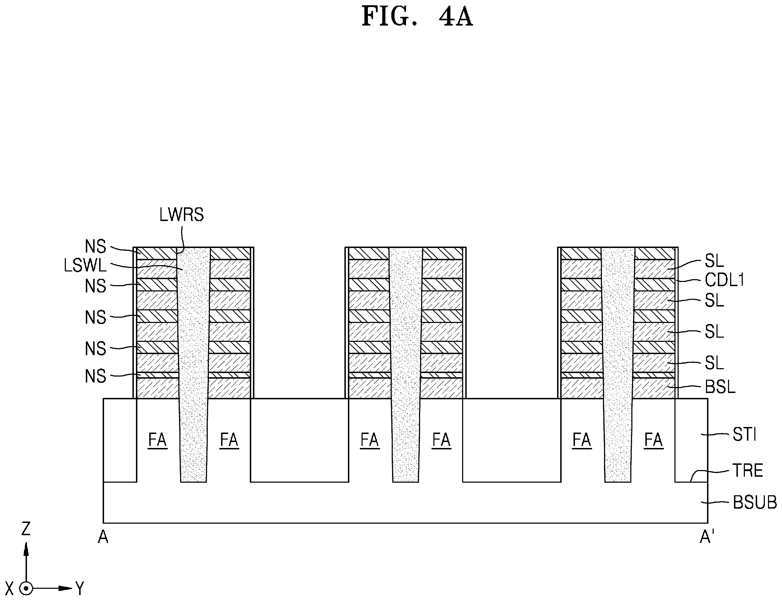

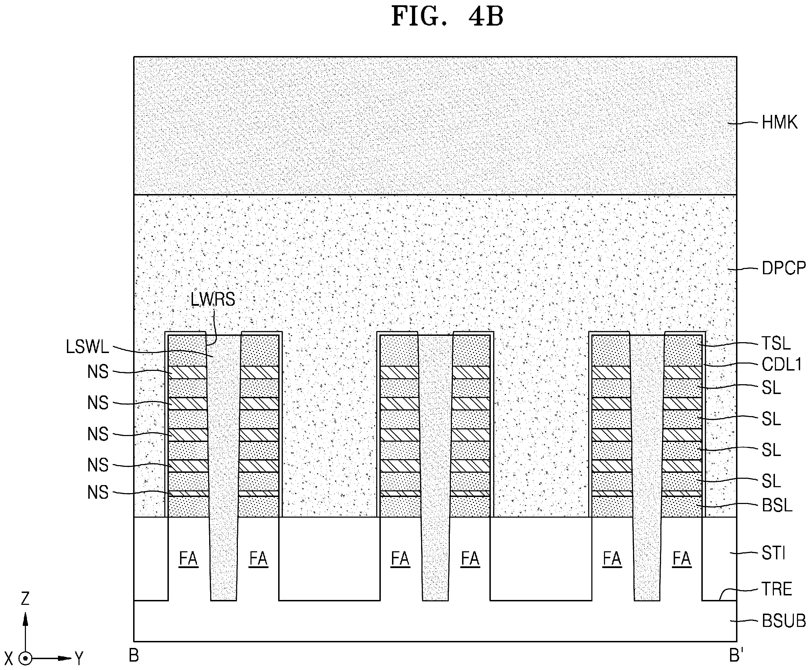

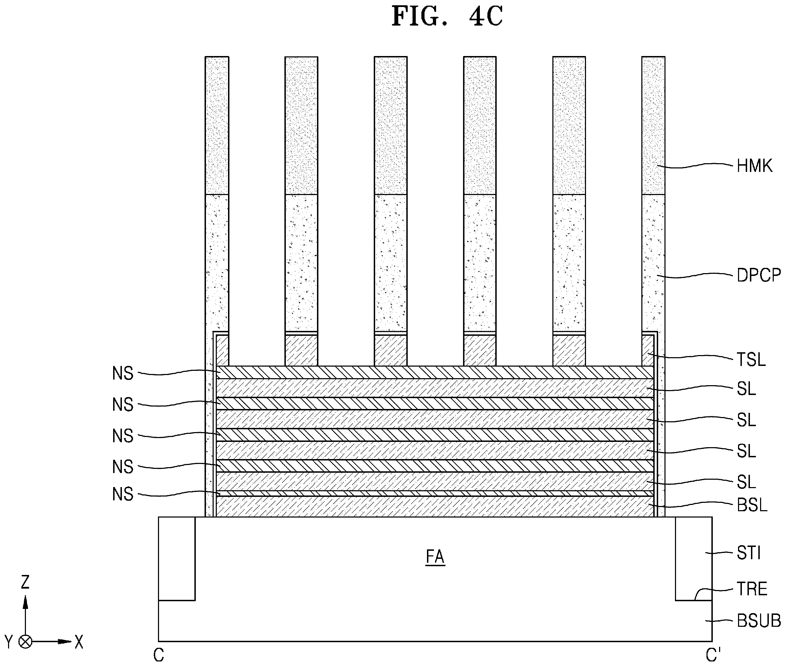

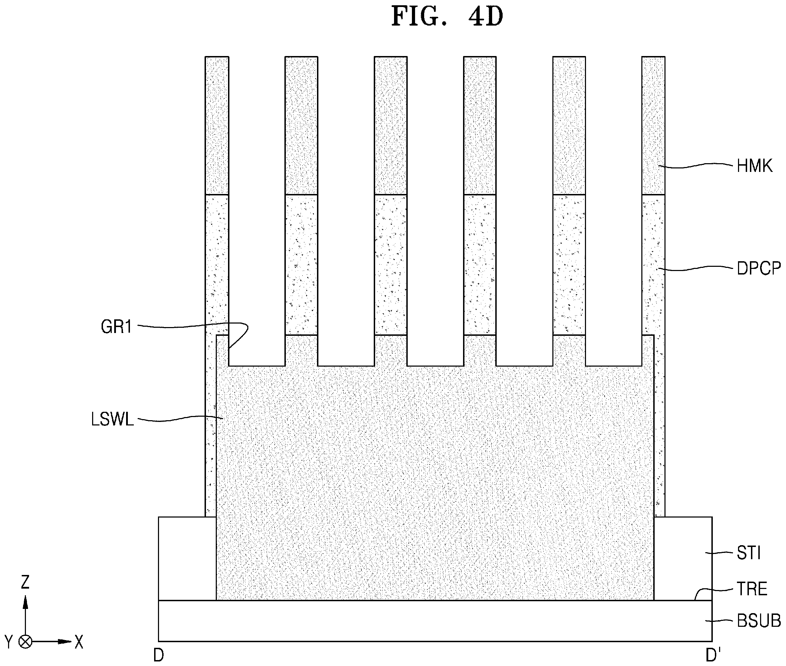

Referring to FIGS. 4A to 4D, a dummy gate electrode DPCP and a plurality of hard mask patterns HMK may be formed on the resultant product of FIGS. 3A to 3D, and then, by patterning the dummy gate electrode DPCP and the first insulation layer CDL1 by using the plurality of hard mask patterns HMK as an etch mask, the dummy gate electrode DPCP and the first insulation layer CDL1 may be respectively divided into a plurality of dummy gate electrodes DPCP and a plurality of first insulation layers CDL1. For example, by patterning the dummy gate electrode DPCP and the first insulation layer CDL1 by using the plurality of hard mask patterns HMK as an etch mask so that the uppermost nanosheet semiconductor layer NS of the plurality of nanosheet semiconductor layers NS and the device isolation layer STI are exposed, the dummy gate electrode DPCP and the first insulation layer CDL1 may be respectively divided into the plurality of dummy gate electrodes DPCP and the plurality of first insulation layers CDL1. In a process of patterning the dummy gate electrode DPCP and the first insulation layer CDL1 to divide into the plurality of dummy gate electrodes DPCP and the plurality of first insulation layers CDL1, portions of the top sacrificial layer TSL disposed under the plurality of dummy gate electrodes DPCP may remain, and the other portions may be removed. In some embodiments, in the process of patterning the dummy gate electrode DPCP and the first insulation layer CDL1 to divide into the plurality of dummy gate electrodes DPCP and the plurality of first insulation layers CDL1, a portion of an upper side of the lower sheet separation wall LSWL may be removed, and thus, a plurality of first grooves GR1 may be formed. The plurality of first grooves GR1 may be disposed under a space between stack structures of a plurality of hard mask patterns HMK and the plurality of dummy gate electrodes DPCP.

The plurality of hard mask patterns HMK may be formed to extend in the second horizontal direction (the Y direction) and be apart from one another in the first horizontal direction (the X direction). Each of the plurality of hard mask patterns HMK may include nitride. For example, each of the plurality of hard mask patterns HMK may include silicon nitride. The plurality of first insulation layers CDL1 and the plurality of dummy gate electrodes DPCP each formed through patterning based on the plurality of hard mask patterns HMK may be formed to extend in the second horizontal direction (the Y direction) and be apart from one another in the first horizontal direction (the X direction). An upper surface of the uppermost nanosheet semiconductor layer NS of the plurality of nanosheet semiconductor layers NS and an upper surface of the device isolation layer STI may be exposed at a lower surface of a space between stack structures of the plurality of first insulation layers CDL1 and the plurality of dummy gate electrodes DPCP. For example, the dummy gate electrode DPCP may include polysilicon, but is not limited thereto. In some embodiments, the first insulation layer CDL1 may be a dummy gate insulation layer. In other some embodiments, before forming the dummy gate electrode DPCP, a separate dummy gate insulation layer may be formed on the first insulation layer CDL1, and in patterning the dummy gate electrode DPCP and the first insulation layer CDL1 to divide into the plurality of dummy gate electrodes DPCP and the plurality of first insulation layers CDL1, the dummy gate insulation layer may be divided into a plurality of dummy gate insulation layers together.

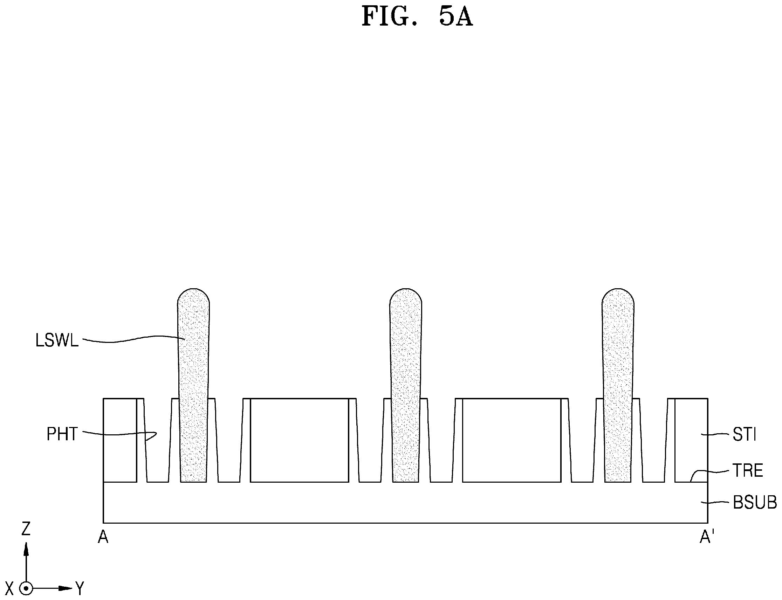

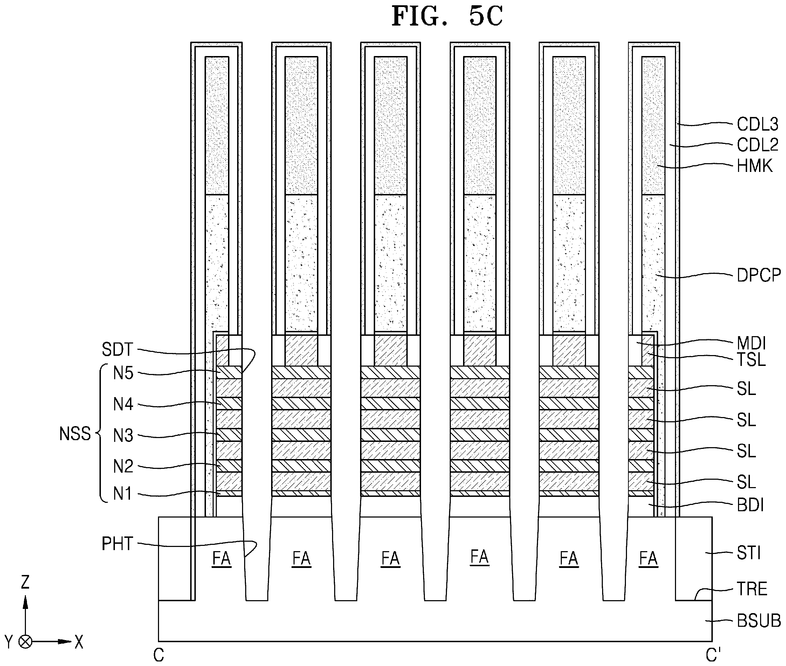

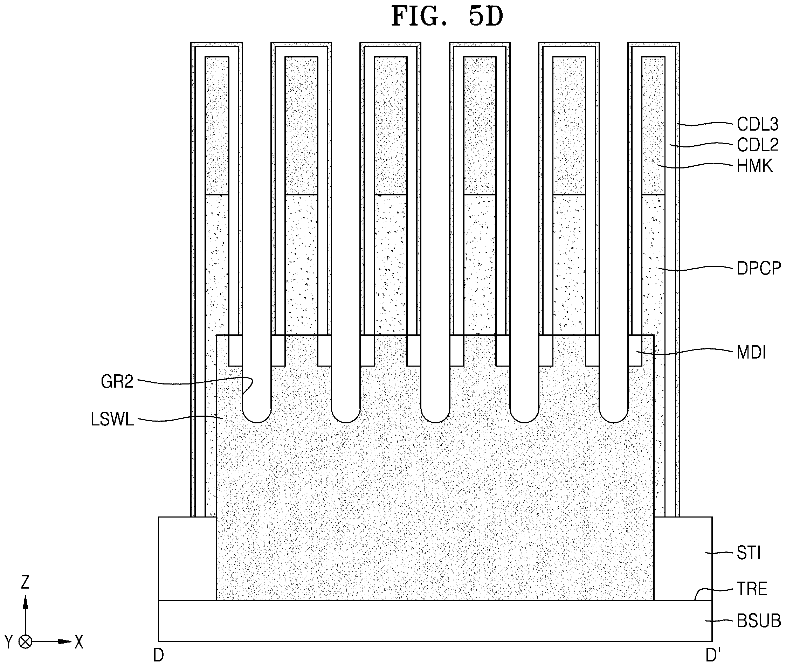

Referring to FIGS. 4A to 4D and 5A to 5D, a plurality of base sacrificial layers BSL may be removed, and then, an insulation material layer filling a space formed by removing the plurality of base sacrificial layers BSL may be formed. For example, the insulation material layer may include silicon nitride (SiN), silicon oxynitride (SiON), silicon carbonitride (SiCN), silicon oxycarbonitride (SiOCN), or a combination thereof. In some embodiments, the insulation material layer may be formed to include an upper surface which is at the same vertical level as an upper surface of the top sacrificial layer TSL.

After the insulation material layer is formed, a plurality of lower insulation layers BDI, a plurality of middle insulation layers MDI, a second insulation layer CDL2, and a third insulation layer CDL3 which are some portions of the insulation material layer may be formed. The plurality of lower insulation layers BDI may be portions of the insulation material layer filling a space from which the plurality of base sacrificial layers BSL are removed. Each of the plurality of middle insulation layers MDI may be disposed between the second insulation layer CDL2, the third insulation layer CDL3, and the uppermost nanosheet semiconductor layer NS of the plurality of nanosheet semiconductor layers NS and may be a portion of the insulation material layer contacting the top sacrificial layer TSL. Each of the second insulation layer CDL2 and the third insulation layer CDL3 may be formed to sequentially and conformally cover surfaces of each of the stack structures of the plurality of first insulation layers CDL1, the plurality of dummy gate electrodes DPCP, and the plurality of hard mask patterns HMK. In some embodiments, the second insulation layer CDL2 may include silicon oxide (SiO), and the third insulation layer CDL3 may include SiN, SiON, SiCN, SiOCN, or a combination thereof.

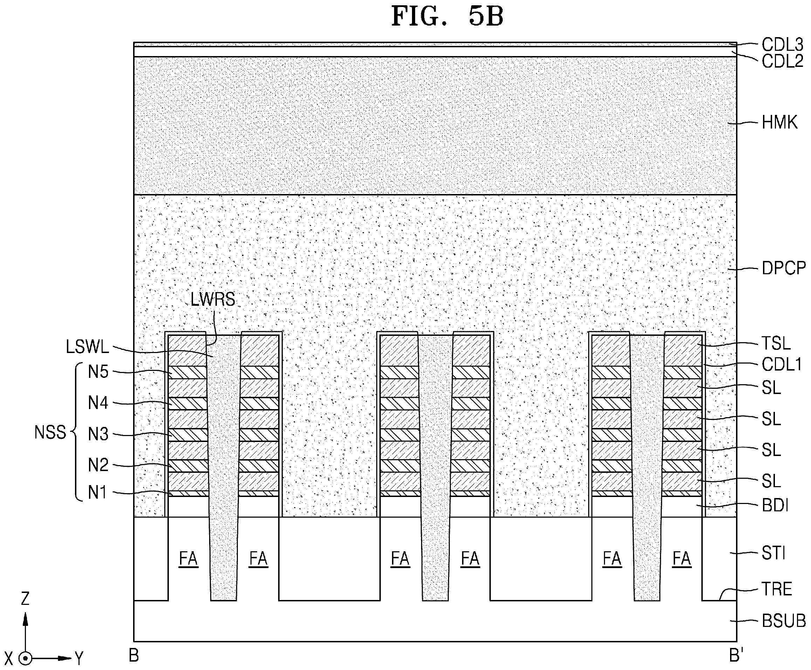

By performing an anisotropic etching process after the second insulation layer CDL2 and the third insulation layer CDL3 are formed, a plurality of nanosheet stack structures NSS each including a plurality of nanosheets N1 to N5 may be formed by removing a portion of a stack structure of the plurality of sacrificial layers SL and the plurality of nanosheet semiconductor layers NS each disposed under a space between the stack structures of the plurality of first insulation layers CDL1, the plurality of dummy gate electrodes DPCP, and the plurality of hard mask patterns HMK. In FIGS. 5B to 5D, it is illustrated that the second insulation layer CDL2 and the third insulation layer CDL3 cover upper surfaces of the plurality of hard mask patterns HMK, but the inventive concepts are not limited thereto. In some embodiments, in a process of forming the plurality of nanosheet stack structures NSS, a portion of the second insulation layer CDL2 and a portion of the third insulation layer CDL3 each covering the upper surfaces of the plurality of hard mask patterns HMK may be removed.

Each of the nanosheet stack structures NSS may include a first nanosheet N1, a second nanosheet N2, a third nanosheet N3, a fourth nanosheet N4, and a fifth nanosheet N5, which are arranged apart from one another in the vertical direction (the Z direction) sequentially from a lower side thereof to an upper side thereof, but the inventive concepts are not limited thereto. For example, the nanosheet stack structure NSS may include three or more nanosheets. Herein, for convenience of description, it may be described that the first nanosheet N1 and the fifth nanosheet N5 are a lowermost nanosheet and an uppermost nanosheet of the plurality of nanosheets N1 to N5 included in the nanosheet stack structure NSS, respectively.

Portions of the plurality of sacrificial layers SL may be disposed between the plurality of nanosheets N1 to N5 included in the nanosheet stack structure NSS. In a process of forming the plurality of nanosheet stack structures NSS each including the plurality of nanosheets N1 to N5, a portion of the insulation material layer may be removed, and thus, the plurality of lower insulation layers BDI and the plurality of middle insulation layers MDI may be formed.

The base substrate layer BSUB and the lower sheet separation wall LSWL may be exposed at the lower surface of a space between the stack structures of the plurality of first insulation layers CDL1, the plurality of dummy gate electrodes DPCP, and the plurality of hard mask patterns HMK. A plurality of source/drain trenches SDT may be defined in a space between the plurality of nanosheet stack structures NSS. In some embodiments, in a process of forming the plurality of nanosheet stack structures NSS each including the plurality of nanosheets N1 to N5, portions of the base substrate layer BSUB disposed under a space (i.e., the plurality of source/drain trenches SDT) between the plurality of nanosheet stack structures NSS may be removed, and thus, a plurality of place holder trenches PHT may be formed. In some embodiments, in a process of forming the plurality of nanosheet stack structures NSS each including the plurality of nanosheets N1 to N5, partial portions of the plurality of lower sheet separation walls LSWL may be removed, and thus, a plurality of second grooves GR2 may be formed.

The plurality of second grooves GR2 may be disposed under a space between the plurality of nanosheet stack structures NSS each including the plurality of nanosheets N1 to N5. For example, in a Y-Z vertical cross-sectional surface configured by the second horizontal direction (the Y direction) and the vertical direction (the Z direction), upper portions of the plurality of lower sheet separation walls LSWL may be rounded (e.g., see FIG. 5A). For example, the Y-Z vertical cross-section may also be referred to as a vertical cross-sectional view aligned parallel to the second horizontal direction (the Y direction), which is a cross-sectional view where the vertical direction (the Z direction) is oriented vertically across the page and the second horizontal direction (the Y direction) is oriented horizontally across the page. As an example, a cross-section taken along a portion corresponding to line A-A' of FIG. 1 or line B-B' of FIG. 1 results in a vertical cross-sectional view aligned parallel to the second horizontal direction (the Y direction). For example, in the Y-Z vertical cross-sectional surface configured by the second horizontal direction (the Y direction) and the vertical direction (the Z direction), the plurality of second grooves GR2 where a lower surface is rounded may be formed in the upper portions of the plurality of lower sheet separation walls LSWL. A horizontal width of the second groove GR2 may be less than a horizontal width of the first groove GR1 in the first horizontal direction (the X direction), and a depth of the second groove GR2 from an uppermost end of the lower sheet separation wall LSWL may be deeper than that of the first groove GR1. That is, a vertical level of a lower surface of the second groove GR2 may be lower than a vertical level of a lower surface of the first groove GR1.

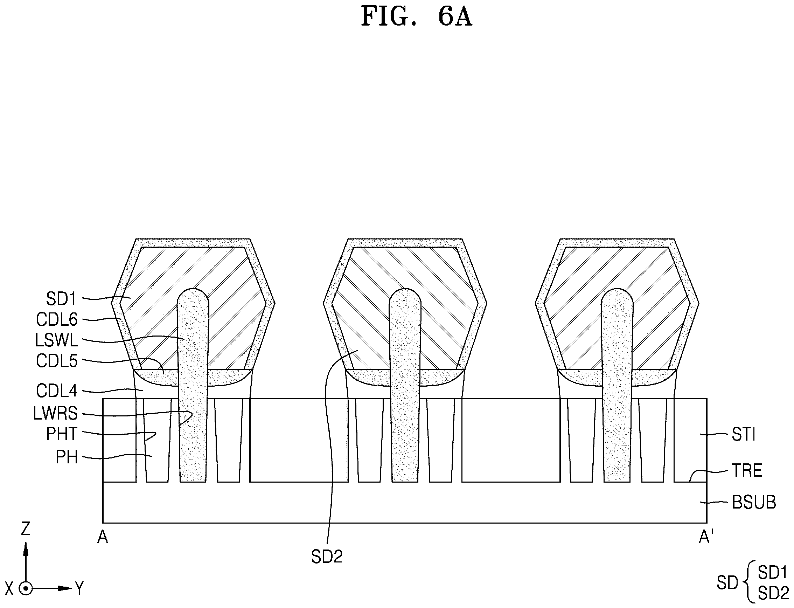

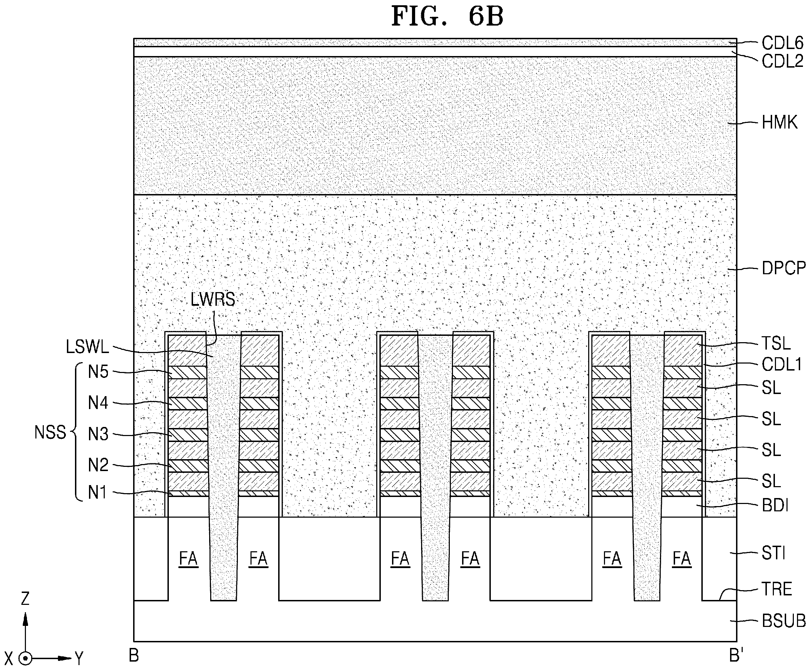

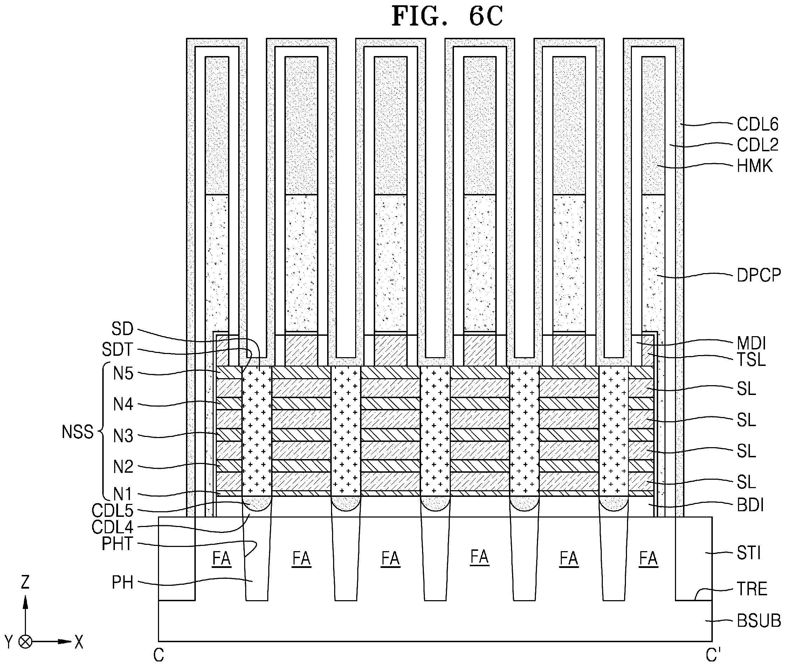

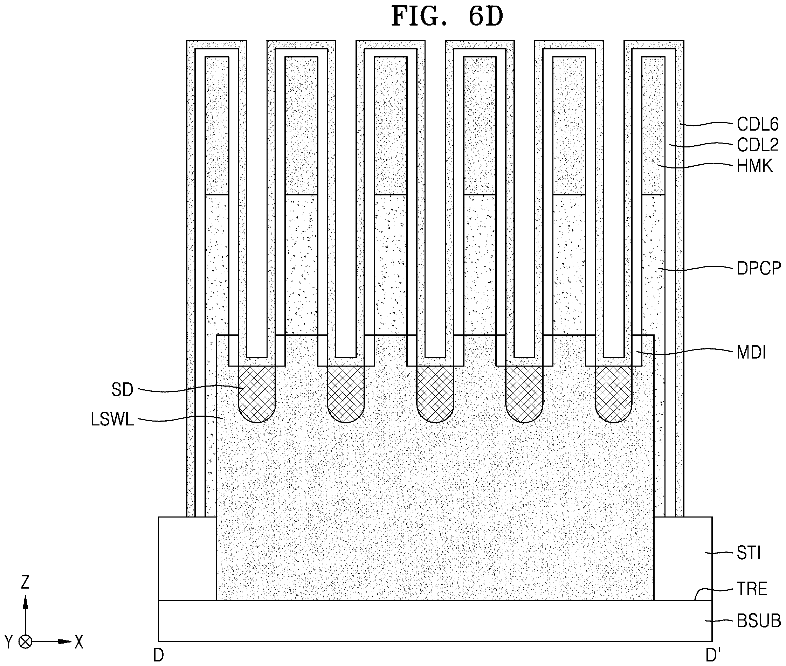

Referring to FIGS. 6A to 6D, a plurality of place holder layers PH filling the plurality of place holder trenches PHT may be formed, and then, a fourth insulation layer CDL4 and a fifth insulation layer CDL5 each on (e.g., covering) the plurality of place holder layers PH may be formed. In some embodiments, the place holder layer PH may include a semiconductor material. For example, the place holder layer PH may include a compound semiconductor such as SiGe. In some embodiments, the place holder layer PH may be formed to include an upper surface at a vertical level which is approximately similar to an upper surface of the device isolation layer STI and the fin-type active region FA. In some embodiments, the fourth insulation layer CDL4 may include SiO, and the fifth insulation layer CDL5 may include SiN, SiON, SiCN, SiOCN, or a combination thereof.

A plurality of source/drain regions SD which are epitaxially-grown from side surfaces of the plurality of nanosheets N1 to N5 included in each of the plurality of nanosheet stack structures NSS and fill the plurality of source/drain trenches SDT may be formed, and then, a sixth insulation layer CDL6 on (e.g., covering) a surface of the resultant product where the plurality of source/drain regions SD may be formed. In some embodiments, a lower surface of the plurality of source/drain regions SD may contact the fifth insulation layer CDL5. A side surface and an upper surface of each of the plurality of source/drain regions SD may contact the sixth insulation layer CDL6.

The plurality of source/drain regions SD may include a first source/drain region SD1 and a second source/drain region SD2. For example, each of the first source/drain region SD1 and the second source/drain region SD2 may include an embedded SiGe structure including a plurality of epitaxially-grown SiGe layers, an epitaxially-grown Si layer, or an epitaxially-grown SiC layer. In some embodiments, the sixth insulation layer CDL6 may include nitride. In some embodiments, the sixth insulation layer CDL6 may include the same material as that of the third insulation layer CDL3 illustrated in FIGS. 5B to 5D, and the sixth insulation layer CDL6 and the third insulation layer CDL3 may be configured as one body (e.g., may form one insulation layer).

In some embodiments, the first source/drain region SD1 and the second source/drain region SD2 may include impurities of different types. In some embodiments, a plurality of nanosheets N1 to N5 contacting the first source/drain region SD1 and a plurality of nanosheets N1 to N5 contacting the second source/drain region SD2 may include impurities of different types. For example, an n-type metal oxide semiconductor (NMOS) transistor may be formed in the first source/drain region SD1, and a p-type metal oxide semiconductor (PMOS) transistor may be formed in the second source/drain region SD2. For example, the first source/drain region SD1 may include n-type impurities, the second source/drain region SD2 may include p-type impurities, the plurality of nanosheets N1 to N5 contacting the first source/drain region SD1 may include p-type impurities, and the plurality of nanosheets N1 to N5 contacting the second source/drain region SD2 may include n-type impurities.

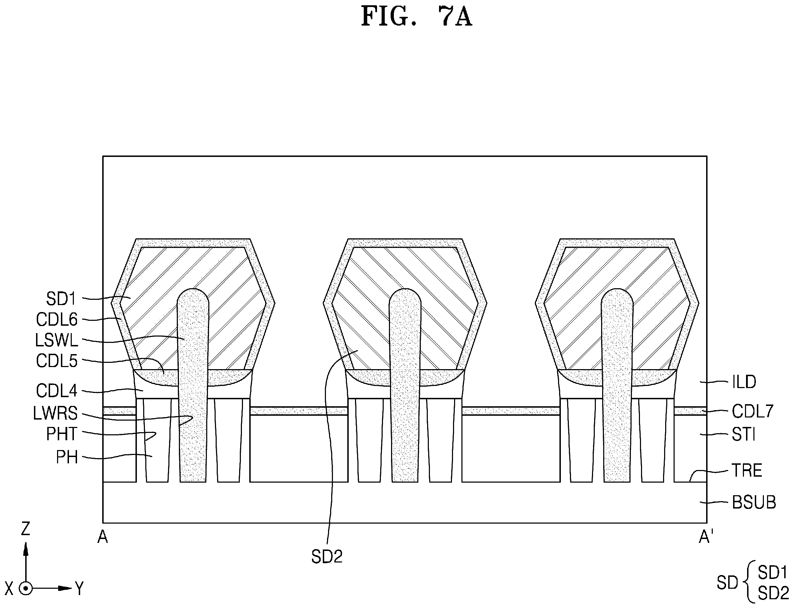

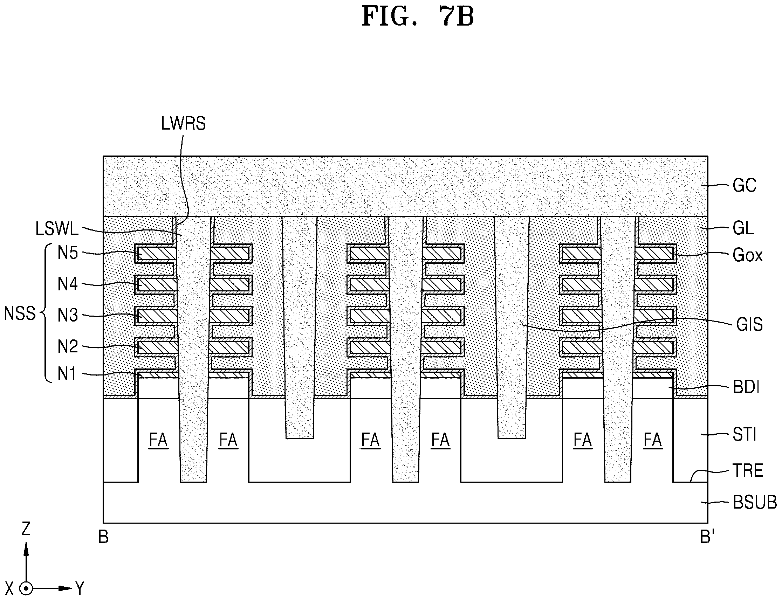

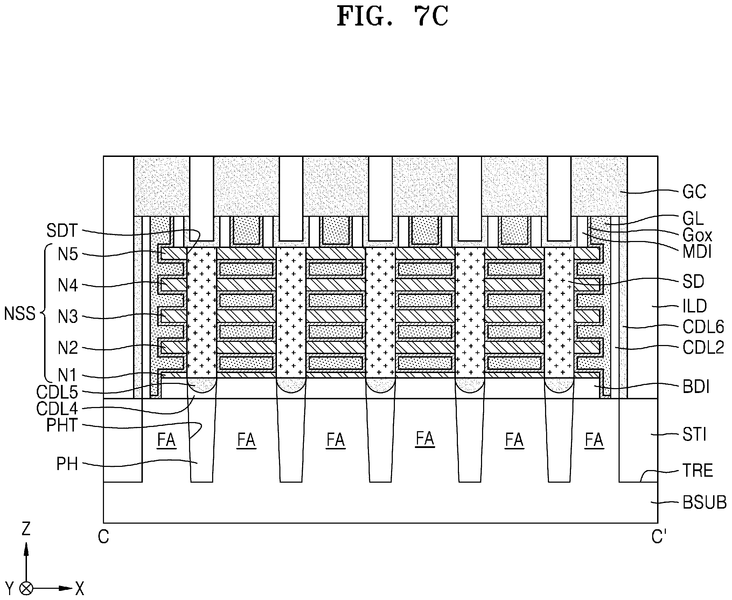

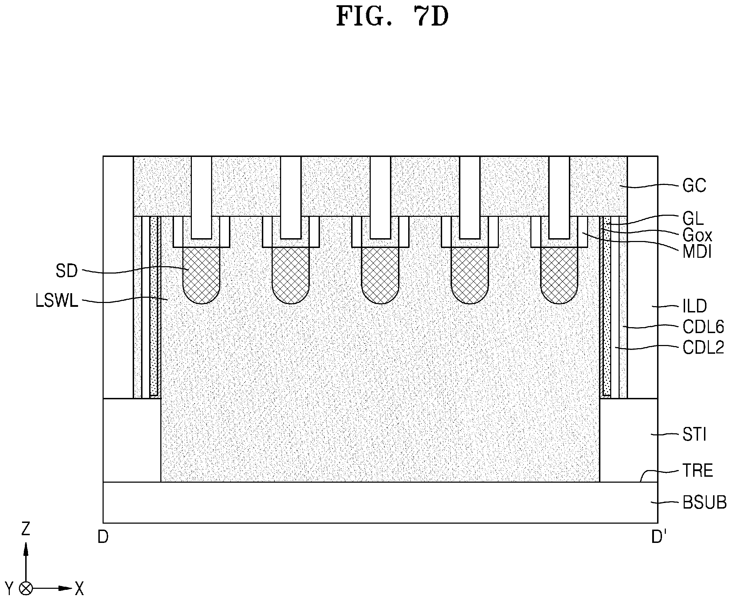

Referring to FIGS. 6A to 6D and 7A to 7D, an interlayer insulation layer ILD on (e.g., covering) the sixth insulation layer CDL6 may be formed. For example, the interlayer insulation layer ILD may include silicon oxide or an insulating material which is lower in dielectric constant than silicon oxide. In some embodiments, the interlayer insulation layer ILD may include a tetraethyl orthosilicate (TEOS) oxide layer or an ultra low-K dielectric (ULK) layer having an ultra low dielectric constant K of about 2.2 to about 2.4. The ULK layer may include a SiOC layer or a SiCOH layer. In some embodiments, before forming the interlayer insulation layer ILD, a portion of an upper side of the device isolation layer STI may be removed, and then, a seventh insulation layer CDL7 on (e.g., covering) the device isolation layer STI may be formed and the interlayer insulation layer ILD may be formed to be on (e.g., to cover) the sixth insulation layer CDL6 and the seventh insulation layer CDL7. For example, the seventh insulation layer CDL7 may include SiN.

After the interlayer insulation layer ILD is formed, the plurality of dummy gate electrodes DPCP may be exposed by removing upper partial portions of the interlayer insulation layer ILD, the sixth insulation layer CDL6, the second insulation layer CDL2, and the hard mask pattern HMK, and then, the plurality of dummy gate electrodes DPCP and the plurality of first insulation layers CDL1 may be removed. In some embodiments, the plurality of dummy gate electrodes DPCP and the plurality of first insulation layers CDL1 may be removed by performing a wet etching process. For example, HNO₃, diluted hydrofluoric acid (DHF), NH₄OH, tetramethyl ammonium hydroxide (TMAH), KOH, or a combination thereof may be used for performing the wet etching process.

After the plurality of dummy gate electrodes DPCP and the plurality of first insulation layers CDL1 are removed, a plurality of gate insulation layers Gox on (e.g., covering) a surface exposed at a space exposed by removing the top sacrificial layer TSL and the plurality of sacrificial layers SL may be formed. The plurality of gate insulation layers Gox may be formed to conformally cover the exposed surfaces of the plurality of nanosheets N1 to N5 included in the nanosheet stack structure NSS. The plurality of gate insulation layers Gox may include silicon oxide, a high-K dielectric layer, or a combination thereof. In some embodiments, the gate insulation layer Gox may include a stack structure of an interfacial layer and a high-K dielectric layer. The interfacial layer may include a low-K dielectric material having a dielectric constant of about 9 or less. For example, the interfacial layer may include oxide, nitride, silicon oxide, silicon nitride, silicon oxynitride, or oxynitride. The high-K dielectric layer may include metal oxide or metal oxynitride. The high-K dielectric layer may include a material which is greater in dielectric constant than silicon oxide. For example, the high-K dielectric layer may have a dielectric constant of about 10 to about 25. The high-K dielectric layer may include a material selected from among hafnium oxide, hafnium oxynitride, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, or a combination thereof, but the material of the high-K dielectric layer is not limited thereto. The high-K dielectric layer may be formed by an ALD process, a CVD process, or a PVD process. The high-K dielectric layer may have a thickness of about 10 angstroms (Å) to about 40 Å, but is not limited thereto. In some embodiments, the interfacial layer may be omitted. For example, the gate insulation layer Gox may include HfO₂, Al₂O₃, HfAlO₃, Ta₂O₃, or TiO₂.

In some embodiments, the gate insulation layer Gox may include a ferroelectric material layer having a ferroelectric characteristic or a paraelectric material layer having a paraelectric characteristic. For example, the gate insulation layer Gox may include one ferroelectric material layer. For example, the gate insulation layer Gox may include a plurality of ferroelectric material layers which are apart from one another. For example, the gate insulation layer Gox may include a stack-layer structure where a plurality of ferroelectric material layers and a plurality of paraelectric material layers are alternately stacked.

A plurality of gate electrodes GL on (e.g., covering) the plurality of gate insulation layers Gox may be formed. For example, the plurality of gate insulation layers Gox and the plurality of gate electrodes GL may be formed by a replacement metal gate (RMG) process. The gate electrodes GL may include a work function metal-containing layer for adjusting a work function, and the work function metal-containing layer may include a gap-fill metal-containing layer filling an upper space of the work function metal-containing layer. The work function metal-containing layer may include at least one metal selected from among titanium (Ti), tungsten (W), ruthenium (Ru), niobium (Nb), molybdenum (Mo), hafnium (Hf), nickel (Ni), cobalt (Co), platinum (Pt), ytterbium (Yb), terbium (Tb), dysprosium (Dy), erbium (Er), and palladium (Pd). In some embodiments, the gate electrode GL may have a structure where a metal nitride layer, a metal layer, a conductive capping layer, and a gap-fill metal layer are sequentially stacked. The metal nitride layer and the metal layer may include at least one metal selected from among Ti, Ta, W, Ru, Nb, Mo, and Hf. The gap-fill metal layer may include a W layer or an Al layer. In some embodiments, the gate electrode GL may include a stack of TiAlC/TiN/W, a stack of TiN/TaN/TiAlC/TiN/W, or a stack of TiN/TaN/TiN/TiAlC/TiN/W, but is not limited thereto.

In some embodiments, at least a portion of the work function metal-containing layer included in a gate electrode GL, formed on a nanosheet stack structure NSS including a plurality of nanosheets N1 to N5 contacting the first source/drain region SD1, of the plurality of gate electrodes GL and at least a portion of the work function metal-containing layer included in a gate electrode GL, formed on a nanosheet stack structure NSS including a plurality of nanosheets N1 to N5 contacting the second source/drain region SD2, of the plurality of gate electrodes GL may include different materials.

In some embodiments, a plurality of gate isolation structures GIS each disposed between a pair of nanosheet stack structures NSS each including a plurality of nanosheets N1 to N5 disposed between a pair of lower separation recesses LWRS adjacent to each other in the second horizontal direction (the Y direction) may be formed. The plurality of gate isolation structures GIS may extend up to an inner portion of the device isolation layer STI from an upper surface of each of the plurality of gate electrodes GL. Each of the plurality of gate isolation structures GIS may be disposed between gate electrodes GL respectively surrounding a pair of nanosheet stack structures NSS disposed between the pair of lower separation recesses LWRS adjacent to each other in the second horizontal direction (the Y direction) may be disposed and may separate the gate electrodes GL respectively surrounding the pair of nanosheet stack structures NSS. In some embodiments, the gate isolation structure GIS may correspond to the gate cut structure PCT illustrated in FIG. 1. It will be understood that "an element A surrounds an element B" (or similar language) as used herein means that the element A is at least partially around the element B but does not necessarily mean that the element A completely encloses the element B.

After the plurality of gate electrodes GL are formed, upper partial portions of the plurality of gate electrodes GL and upper partial portions of the plurality of gate insulation layers Gox may be removed, and then, a plurality of gate capping layers GC filling spaces from which the upper partial portions of the plurality of gate electrodes GL and the upper partial portions of the plurality of gate insulation layers Gox are removed may be formed. For example, the gate capping layer GC may include silicon nitride. In some embodiments, in a process of removing the upper partial portions of the plurality of gate electrodes GL and the upper partial portions of the plurality of gate insulation layers Gox, an upper partial portion of each of the second insulation layer CDL2 and the sixth insulation layer CDL6 may be removed together, and the plurality of gate capping layers GC may be formed to fill spaces from which the upper partial portions of the plurality of gate electrodes GL, the upper partial portions of the plurality of gate insulation layers Gox, the upper partial portion of the second insulation layer CDL2, and the upper partial portion of the sixth insulation layer CDL6 are removed.

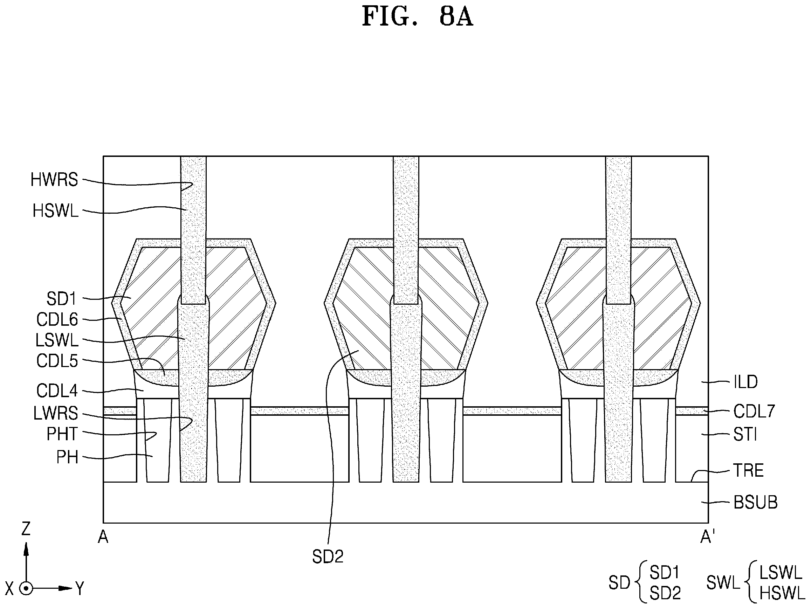

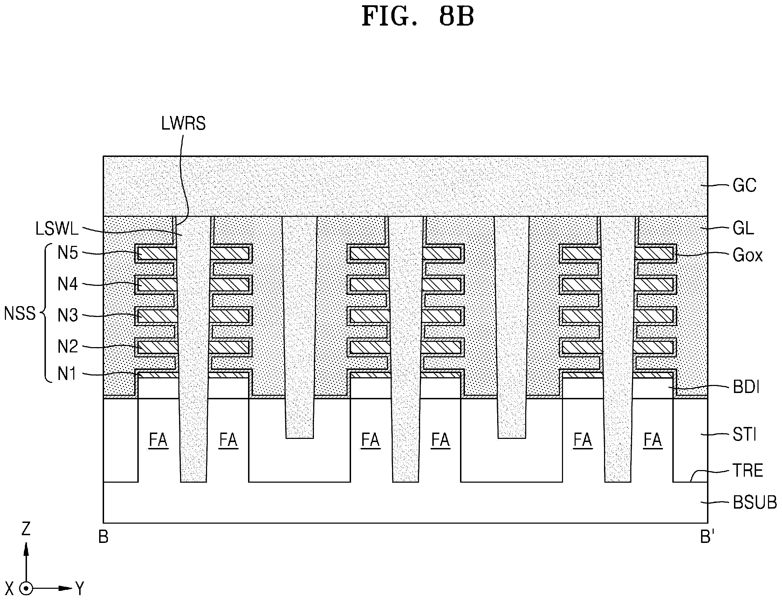

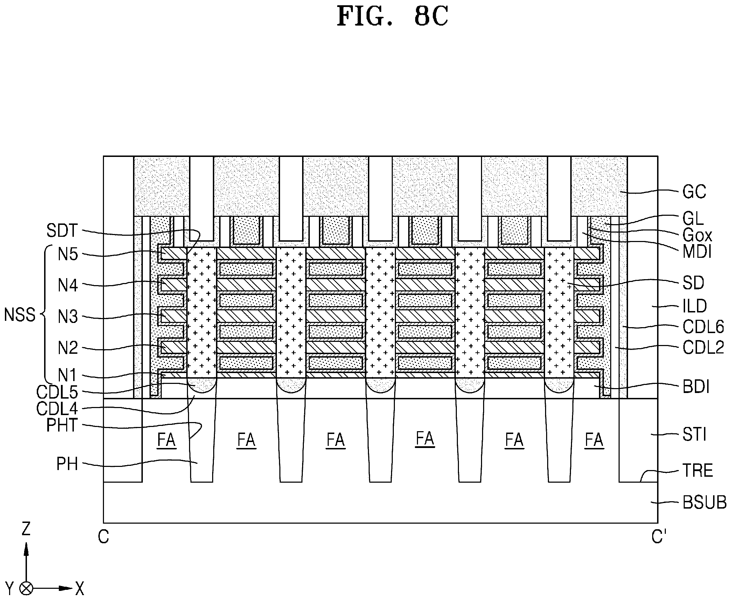

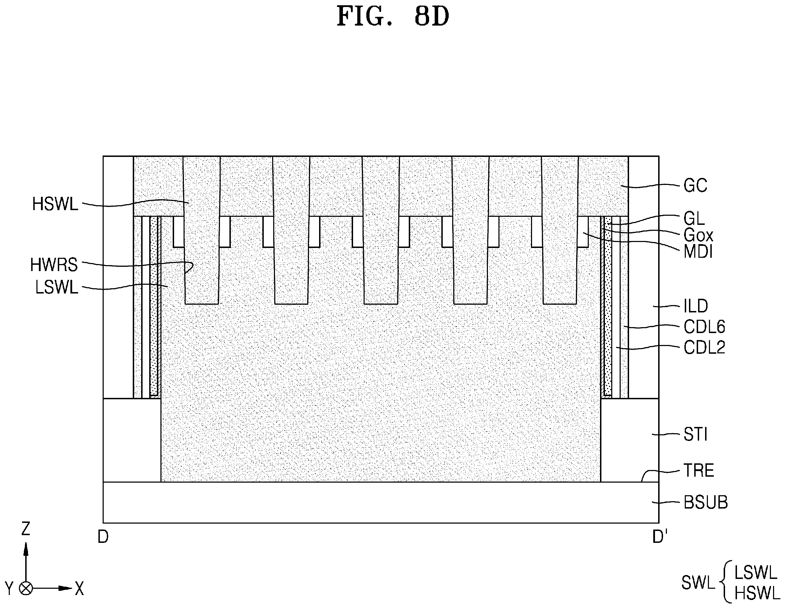

Referring to FIGS. 8A to 8D, a plurality of upper separation recesses HWRS which pass through the interlayer insulation layer ILD and the sixth insulation layer CDL6 and extend into the source/drain region SD may be formed. In some embodiments, the plurality of upper separation recesses HWRS may be arranged and formed in a matrix form so as to be apart from one another in the first horizontal direction (the X direction) and the second horizontal direction (the Y direction). Each of the plurality of upper separation recesses HWRS may pass through the interlayer insulation layer ILD and the sixth insulation layer CDL6 and may extend into the source/drain region SD, and moreover, may be formed so that each of the plurality of lower sheet separation walls LSWL is exposed at a lower surface thereof. For example, in a process of forming the plurality of upper separation recesses HWRS, portions of the plurality of source/drain regions SD arranged on the plurality of lower sheet separation walls LSWL in the vertical direction (the Z direction) may be removed.

Subsequently, a plurality of upper sheet separation walls HSWL respectively filling the plurality of upper separation recesses HWRS may be formed. For example, the upper sheet separation wall HSWL may include silicon nitride. The plurality of upper sheet separation walls HSWL may contact the plurality of lower sheet separation walls LSWL. The plurality of upper sheet separation walls HSWL and the plurality of lower sheet separation walls LSWL may configure a plurality of sheet separation walls SWL. In some embodiments, different upper sheet separation walls HSWL of the plurality of upper sheet separation walls HSWL may contact each of the plurality of lower sheet separation walls LSWL. For example, upper sheet separation walls HSWL contacting one lower sheet separation wall LSWL may be arranged apart from one another to configure a column in the first horizontal direction (the X direction). Each of upper sheet separation walls HSWL which are arranged apart from one another to configure a column in the first horizontal direction (the X direction) may contact different lower sheet separation walls LSWL of the plurality of lower sheet separation walls LSWL.

The plurality of upper sheet separation walls HSWL may extend into the lower sheet separation wall LSWL. In some embodiments, a middle insulation layer MDI may be disposed between an upper portion of the lower sheet separation wall LSWL and the upper sheet separation wall HSWL in the first horizontal direction (the X direction). The lower sheet separation wall LSWL and the upper sheet separation wall HSWL may contact each other at a vertical level which is lower than the middle insulation layer MDI, in the first horizontal direction (the X direction). For example, in an X-Z vertical cross-sectional surface configured by the first horizontal direction (the X direction) and the vertical direction (the Z direction), the upper sheet separation wall HSWL may extend toward a lower end thereof from an upper end thereof and may sequentially contact the gate capping layer GC, the middle insulation layer MDI, and the lower sheet separation wall LSWL. For example, the X-Z vertical cross-section may also be referred to as a vertical cross-sectional view aligned parallel to the first horizontal direction (the X direction), which is a cross-sectional view where the vertical direction (the Z direction) is oriented vertically across the page and the first horizontal direction (the X direction) is oriented horizontally across the page. As an example, a cross-section taken along a portion corresponding to line C-C' of FIG. 1 or line D-D' of FIG. 1 results in a vertical cross-sectional view aligned parallel to the first horizontal direction (the X direction). A side surface of the upper sheet separation wall HSWL may contact the source/drain region SD in the second horizontal direction (the Y direction). For example, in a Y-Z vertical cross-sectional surface configured by the second horizontal direction (the Y direction) and the vertical direction (the Z direction), the upper sheet separation wall HSWL may extend toward a lower end thereof from an upper end thereof, and moreover, may pass through the interlayer insulation layer ILD, the sixth insulation layer CDL6, and the source/drain region SD and may contact the lower sheet separation wall LSWL.

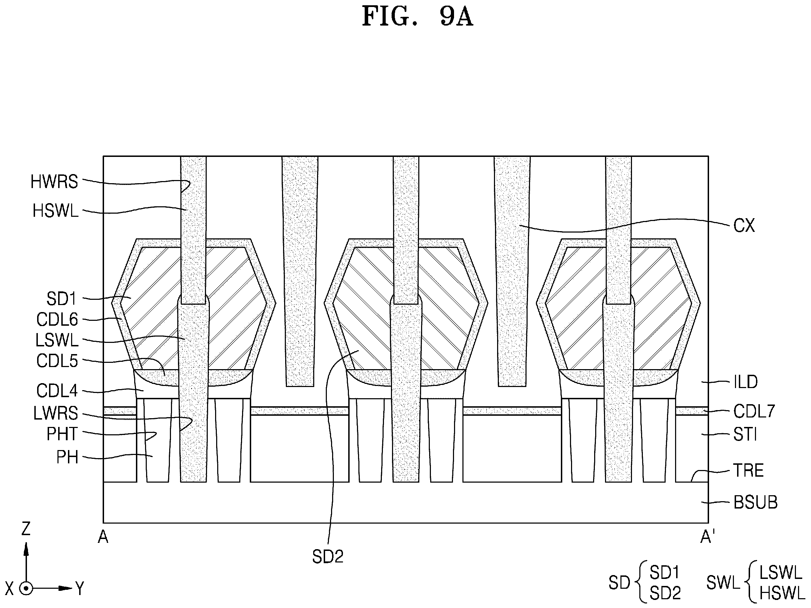

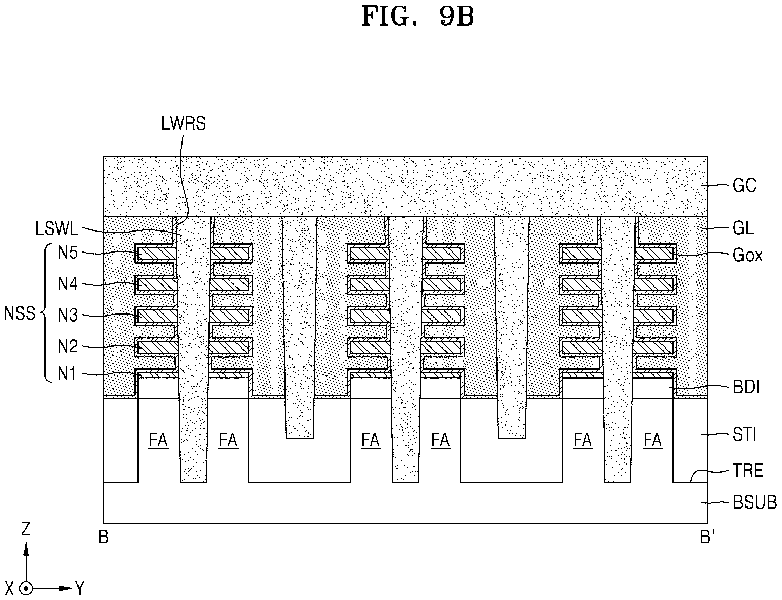

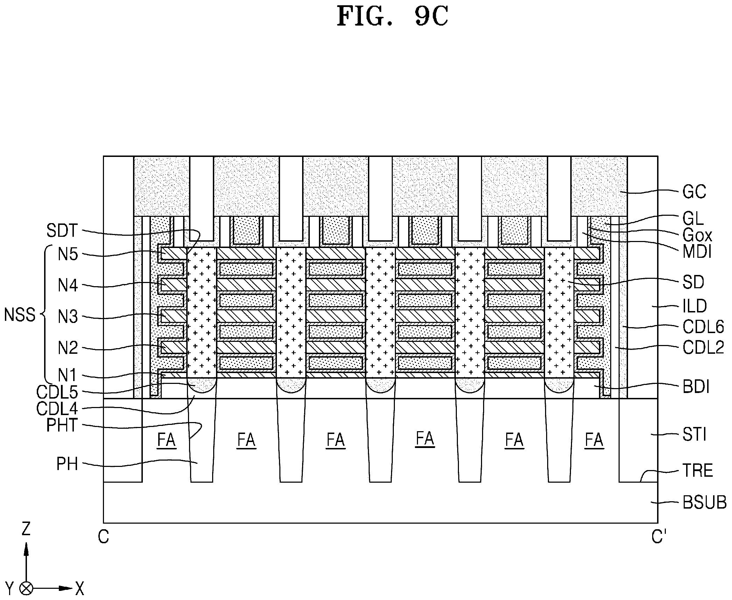

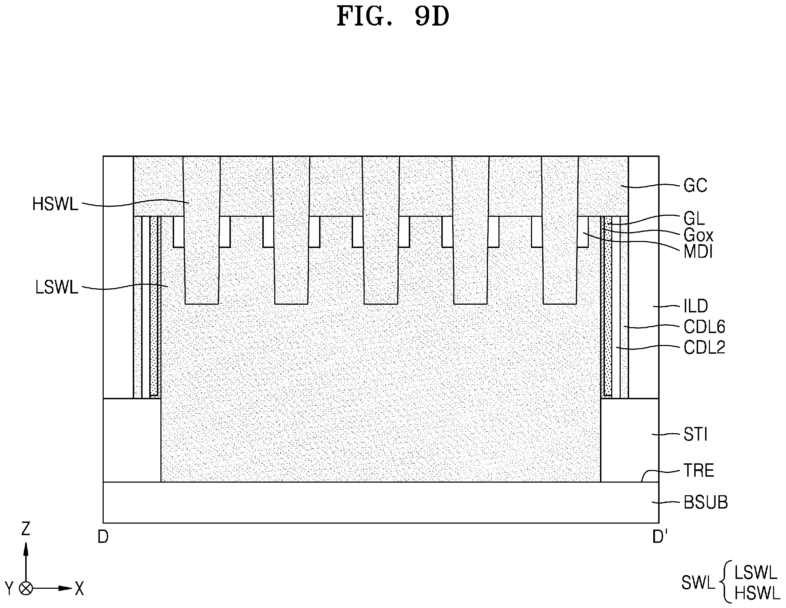

Referring to FIGS. 9A to 9D, a plurality of contact cut structures CX which pass through an upper partial portion of the interlayer insulation layer ILD and extend to a region between source/drain regions SD adjacent to each other in the second horizontal direction (the Y direction) may be formed. For example, the contact cut structure CX may include silicon nitride. In some embodiments, the contact cut structure CX may not extend down to a lower surface of the interlayer insulation layer ILD, and thus, a lower end of the contact cut structure CX may contact the interlayer insulation layer ILD, but the inventive concepts are not limited thereto.

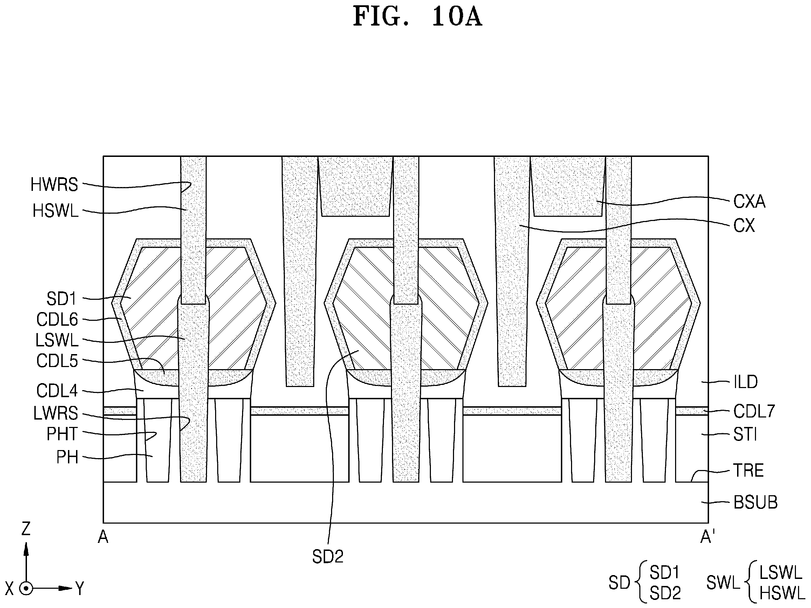

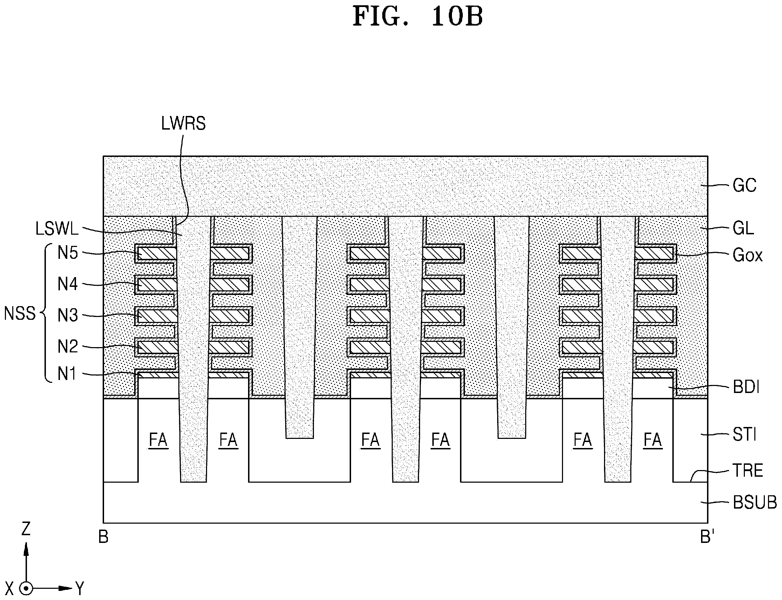

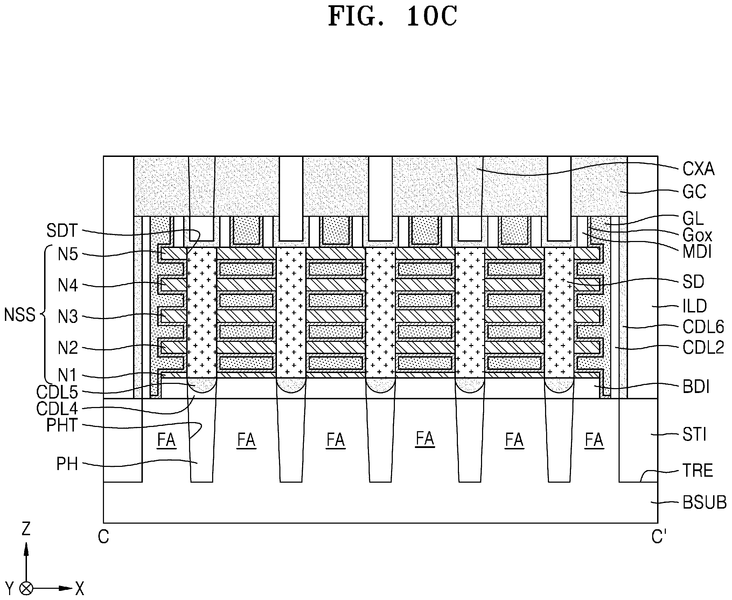

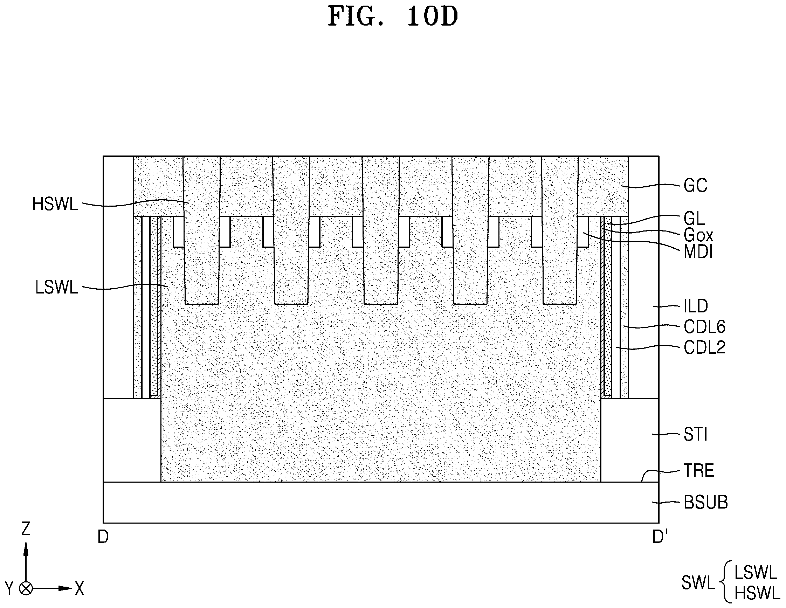

Referring to FIGS. 10A to 10D, a plurality of contact cut connection structures CXA disposed between contact cut structures CX adjacent to each other in the second horizontal direction (the Y direction) may be formed by removing an upper partial portion of the interlayer insulation layer ILD. For example, the contact cut connection structure CXA may include silicon nitride. The contact cut connection structure CXA may be formed to contact each of a pair of contact cut structures CX adjacent to each other in the second horizontal direction (the Y direction). A lower surface of the contact cut connection structure CXA may be at a vertical level which is higher than an upper end of the source/drain region SD.

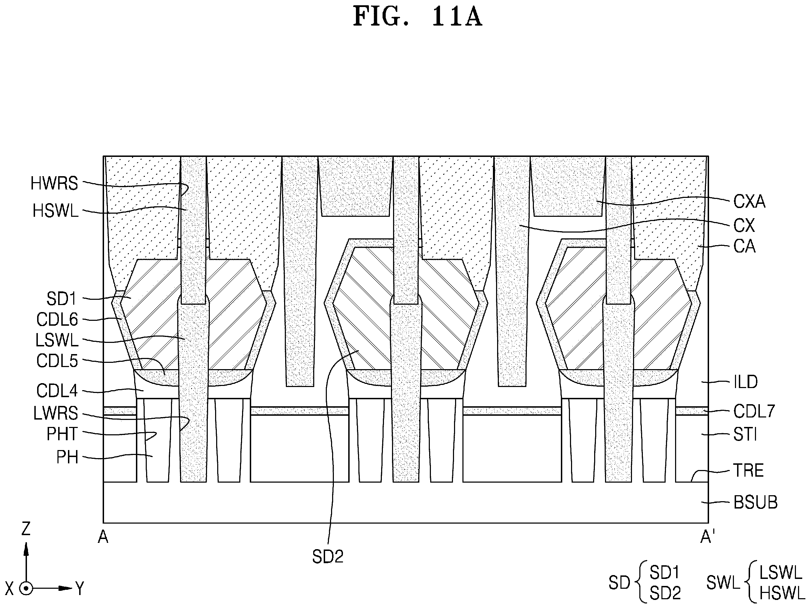

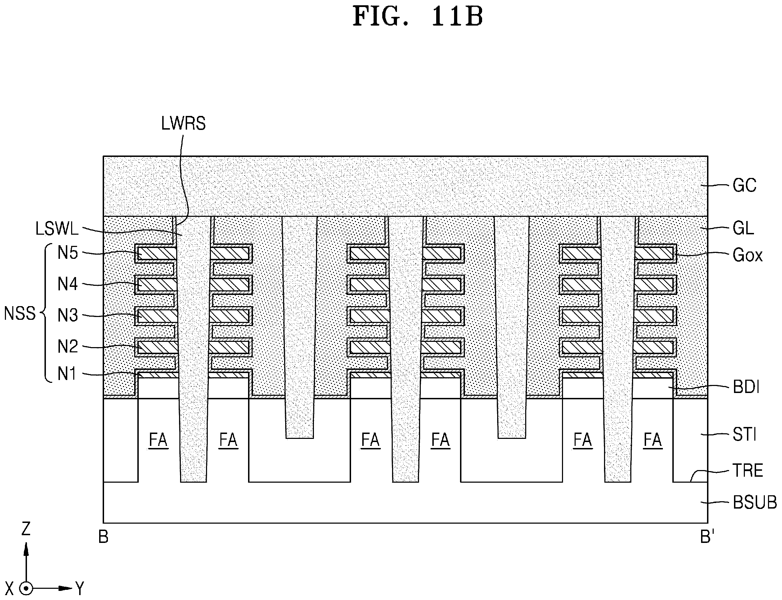

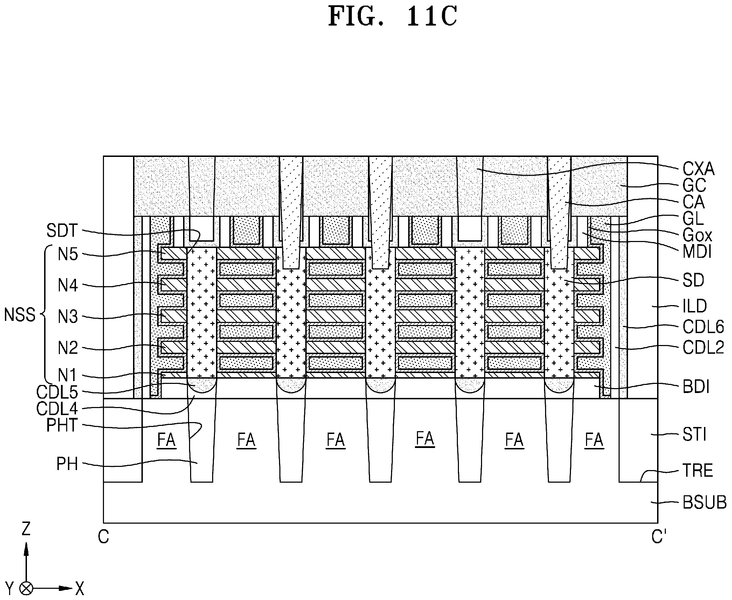

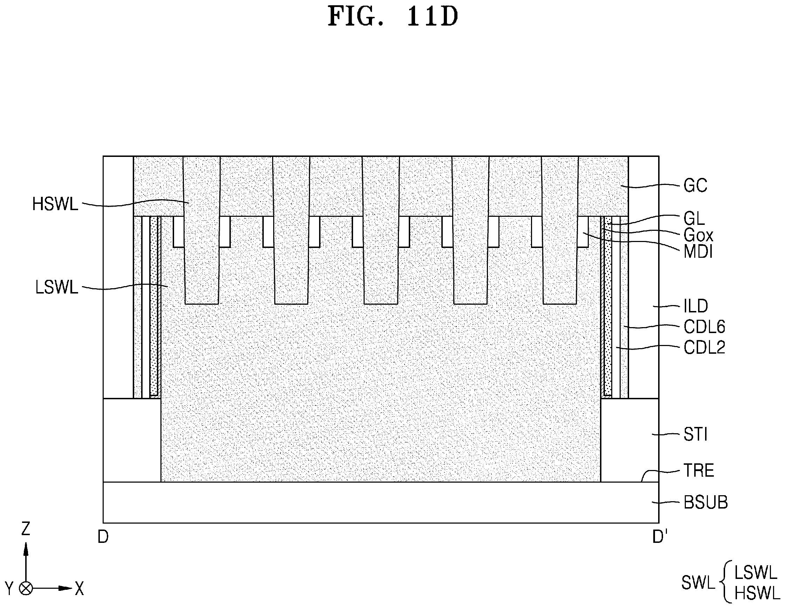

Referring to FIGS. 11A to 11D, a plurality of first contacts CA which pass through an upper partial portion of the interlayer insulation layer ILD and the sixth insulation layer CDL6 and contact the plurality of source/drain regions SD may be formed. Portions of the interlayer insulation layer ILD and portions of the sixth insulation layer CDL6 thereunder, which are not covered by the plurality of contact cut structures CX and the plurality of contact cut connection structures CXA, may be removed, and then, spaces from which the portions of the interlayer insulation layer ILD and the portions of the sixth insulation layer CDL6 thereunder are removed may be filled with a conductive material, thereby forming the plurality of first contacts CA.

Each of the plurality of first contacts CA may include metal, conductive metal nitride, or a combination thereof. For example, each of the plurality of first contacts CA may include a metal material such as W, Al, Cu, Ti, Ta, Ru, Mn, or Co, metal nitride such as TiN, TaN, CoN, or WN, or an alloy such as cobalt tungsten phosphide (CoWP), cobalt tungsten boron (CoWB), or cobalt tungsten boron phosphide (CoWBP). In some embodiments, each of the plurality of first contacts CA may one-dimensionally have a line shape or a bar shape, or may have a vertical pillar shape which extends in the vertical direction (the Z direction).

In some embodiments, a metal silicide layer may be disposed between the plurality of source/drain regions SD and the plurality of first contacts CA. For example, the metal silicide layer may include tungsten silicide (WSi), titanium silicide (TiSi), cobalt silicide (CoSi), or nickel silicide (NiSi).

Referring to FIGS. 12A to 12D, an upper insulation layer UDI on (e.g., covering) the plurality of contact cut structures CX, the plurality of contact cut connection structures CXA, the plurality of sheet separation walls SWL, the plurality of gate capping layers GC, and the plurality of first contacts CA may be formed, and then, a plurality of via plugs CAV which pass through the upper insulation layer UDI and are connected to the plurality of first contacts CA and a plurality of second contacts CB which pass through the plurality of gate capping layers GC and are connected to the plurality of gate electrodes GL may be formed, thereby manufacturing the integrated circuit device 1. As used herein, "an element A connected to an element B" (or similar language) means that the element A is physically and/or electrically connected to the element B.

Each of the plurality of via plugs CAV and the plurality of second contacts CB may include metal, conductive metal nitride, or a combination thereof. For example, each of the plurality of via plugs CAV and the plurality of second contacts CB may include a metal material such as W, Al, Cu, Ti, Ta, Ru, Mn, or Co, metal nitride such as TiN, TaN, CoN, or WN, or an alloy such as CoWP, CoWB, or CoWBP. In some embodiments, each of the plurality of via plugs CAV and the plurality of second contacts CB may one-dimensionally have a circular shape, an oval shape, or a polygonal shape, or may have a vertical pillar shape which extends in the vertical direction (the Z direction).

Referring to FIGS. 1 and 12A to 12D, an integrated circuit device 1 may include a plurality of nanosheet stack structures NSS each including a plurality of nanosheets N1 to N5 on a base substrate layer BSUB, a plurality of sheet separation walls SWL extending in a first horizontal direction (an X direction) on the base substrate layer BSUB, and a plurality of gate electrodes GL extending in a second horizontal direction (a Y direction) on the plurality of nanosheet stack structures NSS. In some embodiments, the integrated circuit device 1 may further include at least one gate cut structure PCT which extends in the first horizontal direction (the X direction) and cuts at least some of the plurality of gate electrodes GL. Two gate electrodes GL divided by the gate cut structure PCT may be apart from each other in the second horizontal direction (the Y direction) with the gate cut structure PCT therebetween.

The plurality of nanosheet stack structures NSS may be arranged to configure rows and columns in the first horizontal direction (the X direction) and the second horizontal direction (the Y direction). The plurality of nanosheet stack structures NSS may be adjacent to the plurality of sheet separation walls SWL and may be arranged to configure columns in the first horizontal direction (the X direction). A pair of nanosheet stack structures NSS corresponding to each other among the plurality of nanosheet stack structures NSS may be disposed apart from each other in the second horizontal direction (the Y direction) with the sheet separation wall SWL therebetween. A pair of source/drain regions SD, connected to a pair of nanosheet stack structures NSS which are apart from each other in the second horizontal direction (the Y direction) with the sheet separation wall SWL therebetween, may be disposed apart from each other in the second horizontal direction (the Y direction) with the sheet separation wall SWL therebetween.

Each of the plurality of nanosheets N1 to N5 included in each of the plurality of nanosheet stack structures NSS may extend in parallel with an upper surface of the base substrate layer BSUB. The plurality of nanosheets N1 to N5 may be stacked apart from one another in a vertical direction (a Z direction) on the base substrate layer BSUB. One end of each of the plurality of nanosheets N1 to N5 included in each of the plurality of nanosheet stack structures NSS may face a corresponding sheet separation wall SWL of the plurality of sheet separation walls SWL.

The plurality of gate electrodes GL may be disposed on an uppermost fifth nanosheet N5 of the plurality of nanosheets N1 to N5 and between each of the plurality of nanosheets N1 to N5. A portion, disposed on the uppermost fifth nanosheet N5, of each of the plurality of gate electrodes GL may be connected to a portion, disposed between two adjacent nanosheets of the plurality of nanosheets N1 to N5, of the plurality of gate electrodes GL.

A plurality of gate insulation layers Gox may be disposed between the plurality of gate electrodes GL and the plurality of nanosheet stack structures NSS each including the plurality of nanosheets N1 to N5. A plurality of first source/drain regions SD1 and a plurality of second source/drain regions SD2 may be respectively connected to the plurality of nanosheets N1 to N5 included in each of the plurality of nanosheet stack structures NSS. The plurality of first source/drain regions SD 1 and the plurality of second source/drain regions SD2 may be respectively connected to the other ends of the plurality of nanosheets N1 to N5 included in each of the plurality of nanosheet stack structures NSS.

The plurality of nanosheet stack structures NSS each including the plurality of nanosheets N1 to N5, the plurality of gate electrodes GL, the plurality of first source/drain regions SD1, and the plurality of second source/drain regions SD2 may configure a plurality of multi-gate metal-oxide-semiconductor field-effect transistors (MOSFETs).

A lower insulation layer BDI may be disposed between the base substrate layer BSUB and the plurality of nanosheet stack structures NSS each including the plurality of nanosheets N1 to N5. A device isolation layer STI may be disposed in the base substrate layer BSUB which does not overlap the plurality of nanosheet stack structures NSS each including the plurality of nanosheets N1 to N5 in the vertical direction (the Z direction).

An interlayer insulation layer ILD may be on (e.g., may cover) a plurality of source/drain regions SD. A plurality of first contacts CA may pass through an upper partial portion of the interlayer insulation layer ILD and a sixth insulation layer CDL6 and may be connected to the plurality of source/drain regions SD. A plurality of second contacts CB may pass through an upper insulation layer UDI and a plurality of gate capping layers GC and may be connected to the plurality of gate electrodes GL. A plurality of via plugs CAV may pass through the upper insulation layer UDI and may be connected to the plurality of first contacts CA.

A pair of nanosheet stack structures NSS adjacent to each other in the second horizontal direction (the Y direction) may be apart from the sheet separation wall SWL. In some embodiments, side surfaces of a plurality of nanosheets N1 to N5 included in each of a pair of nanosheet stack structures NSS adjacent to each other in the second horizontal direction (the Y direction) with the sheet separation wall SWL therebetween may contact the sheet separation wall SWL. In some other embodiments, a plurality of cladding patterns (not shown) may be disposed between the side surfaces of the plurality of nanosheets N1 to N5 and the sheet separation wall SWL. Each of the plurality of cladding patterns may have a thickness of about 2 nanometers (nm) to about 3 nm in the second horizontal direction (the Y direction).

A horizontal width of each of a plurality of nanosheets N1 to N5 included in each of a plurality of nanosheet stack structures NSS disposed at one side and a horizontal width of each of a plurality of nanosheets N1 to N5 included in each of a plurality of nanosheet stack structures NSS disposed at the other side may have the same value, in the second horizontal direction (the Y direction) with the sheet separation wall SWL. For example, a horizontal width of each of the plurality of nanosheets N1 to N5 included in each of the plurality of nanosheet stack structures NSS in the second horizontal direction (the Y direction) may be about 10 nm to about 20 nm.

The plurality of sheet separation walls SWL may include a plurality of upper sheet separation walls HSWL and a plurality of lower sheet separation walls LSWL. The plurality of lower sheet separation walls LSWL may be apart from one another in the second horizontal direction (the Y direction) and may extend in the first horizontal direction (the X direction). The plurality of upper sheet separation walls HSWL may be arranged and formed in a matrix form so as to be apart from one another in the first horizontal direction (the X direction) and the second horizontal direction (the Y direction).

In some embodiments, each of the plurality of sheet separation walls SWL may include a lower sheet separation wall LSWL and upper sheet separation walls HSWL disposed on the lower sheet separation wall LSWL. The lower sheet separation wall LSWL may fill the lower separation recess LWRS, and the upper sheet separation wall HSWL may fill the upper separation recess HWRS. In some embodiments, the lower sheet separation wall LSWL and the upper sheet separation walls HSWL connected to each other may be configured as one body (e.g., may form one separation wall). With respect to the second horizontal direction (the Y direction), a center line LCL of the lower sheet separation wall LSWL and a center line HCL of the upper sheet separation wall HSWL may be aligned with each other in the vertical direction (the Z direction) (e.g., see FIG. 12A). For example, the center line LCL of the lower sheet separation wall LSWL may be a vertical line that intersects a center point of the lower sheet separation wall LSWL, with the center point of the lower sheet separation wall LSWL being taken in the second horizontal direction (the Y direction). The center line HCL of the upper sheet separation wall HSWL may be a vertical line that intersects a center point of the upper sheet separation wall HSWL, with the center point of the upper sheet separation wall HSWL being taken in the second horizontal direction (the Y direction). The center point of the lower sheet separation wall LSWL in the second horizontal direction (the Y direction) and the center point of the upper sheet separation wall HSWL in the second horizontal direction (the Y direction) may be aligned with each other along the vertical direction (the Z direction).

The lower separation recess LWRS may pass through a fifth insulation layer CDL5 and a fourth insulation layer CDL4 from the source/drain region SD and may extend into the base substrate layer BSUB. The plurality of lower separation recesses LWRS may be apart from one another in the second horizontal direction (the Y direction) and may extend in the first horizontal direction (the X direction).

The upper separation recess HWRS may pass through the interlayer insulation layer ILD and the gate capping layer GC and may extend into the source/drain region SD and the lower sheet separation wall LSWL. In some embodiments, the plurality of upper separation recesses HWRS may be arranged and formed in a matrix form so as to be apart from one another in the first horizontal direction (the X direction) and the second horizontal direction (the Y direction). For example, upper sheet separation walls HSWL which are apart from the first horizontal direction (the X direction) and are arranged to configure a column that may extend into one lower sheet separation wall LSWL extending in the first horizontal direction (the X direction). For example, each of upper sheet separation walls HSWL which are arranged apart from one another to configure a column in the first horizontal direction (the X direction) may extend into different lower sheet separation walls LSWL of the plurality of lower sheet separation walls LSWL. In some embodiments, a middle insulation layer MDI may be disposed between an upper portion of the lower sheet separation wall LSWL and the upper sheet separation wall HSWL in the first horizontal direction (the X direction).

A lowermost end of the source/drain region SD may be disposed at a first vertical level LV1, a lowermost end of the upper sheet separation wall HSWL may be disposed at a second vertical level LV2 which is higher than the first vertical level LV1, the sheet separation wall SWL may include a round portion CVP (which may also be referred to as a convex portion) between the second vertical level LV2 and a third vertical level LV3 which is higher than the second vertical level LV2, an uppermost end of the lower sheet separation wall LSWL may be disposed at a fourth vertical level LV4 which is higher than the third vertical level LV3, and an uppermost end of the upper sheet separation wall HSWL may be disposed at a fifth vertical level LV5 which is higher than the fourth vertical level LV4. A lowermost end of the lower sheet separation wall LSWL may be disposed to be lower than the first vertical level LV1. The lower sheet separation wall LSWL may pass through the fifth insulation layer CDL5 and the fourth insulation layer CDL4 from the source/drain region SD and may extend into the base substrate layer BSUB. For example, a lower portion of the lower sheet separation wall LSWL may be buried in the base substrate layer BSUB.

An uppermost end of the lower sheet separation wall LSWL may be disposed at the third vertical level LV3 and a lowermost end of an upper surface of the lower sheet separation wall

LSWL may be disposed at the second vertical level LV2, between a pair of source/drain regions SD which are arranged apart from each other in the second horizontal direction (the Y direction) with the sheet separation wall SWL therebetween. In other words, an uppermost end of a portion of the lower sheet separation wall LSWL between a pair of source/drain regions SD may be at the third vertical level LV3. An uppermost end SDC of the source/drain region SD may be disposed to be higher than the third vertical level LV3 and lower than the fourth vertical level LV4. For example, the uppermost end SDC of the source/drain region SD may contact the upper sheet separation wall HSWL.

In some embodiments, an upper surface of the gate electrode GL and a lower surface of the gate capping layer GC may be at the fourth vertical level LV4, and an upper surface of the gate capping layer GC may be at the fifth vertical level LV5. For example, an uppermost end of the upper sheet separation wall HSWL and the upper surface of the gate capping layer GC may both be at the fifth vertical level LV5 (i.e., may be coplanar with each other). In other words, an uppermost end of the sheet separation wall SWL and the upper surface of the gate capping layer GC may be coplanar with each other.

A thickness of a portion of the gate electrode GL disposed at an upper side from an upper surface of an uppermost nanosheet semiconductor layer NS of a plurality of nanosheet semiconductor layers NS may be equal to that of the top sacrificial layer TSL illustrated in FIGS. 2A to 2C. Also, a thickness of a portion of the lower sheet separation wall LSWL disposed at the upper side from the upper surface of the uppermost nanosheet semiconductor layer NS of the plurality of nanosheet semiconductor layers NS may be equal to that of the top sacrificial layer TSL illustrated in FIGS. 2A to 2C. Therefore, as a thickness of the top sacrificial layer TSL illustrated in FIGS. 2A to 2C is adjusted, a thickness of a portion of the lower sheet separation wall LSWL and a thickness of a portion of the gate electrode GL disposed at the upper side from the upper surface of the uppermost nanosheet semiconductor layer NS may be adjusted. For example, each of a thickness of a portion of the lower sheet separation wall LSWL and a thickness of a portion of the gate electrode GL disposed at the upper side from the upper surface of the uppermost nanosheet semiconductor layer NS may be about 10 nm to about 30 nm.

Both (i.e., opposing) side surfaces of the sheet separation wall SWL in the second horizontal direction (the Y direction) may include a round portion CVP which is rounded convexly toward the outside between a pair of source/drain regions SD which are arranged apart from each other in the second horizontal direction (the Y direction) with the sheet separation wall SWL therebetween and may be flat surfaces (i.e., planar surfaces) between a pair of nanosheet stack structures NSS. In other words, opposing side surfaces of the sheet separation wall SWL in the second horizontal direction (the Y direction) may include a round portion CVP having a convex shape between a pair of source/drain regions SD. For example, in a Y-Z vertical cross-sectional surface configured by the second horizontal direction (the Y direction) and the vertical direction (the Z direction), both side surfaces of the upper sheet separation wall HSWL in the second horizontal direction (the Y direction) may include a portion which is rounded convexly toward the outside to correspond to the round portion CVP, between a pair of source/drain regions SD which are arranged apart from each other in the second horizontal direction (the Y direction) with the sheet separation wall SWL therebetween, or may be a straight line which extends in one direction between a pair of nanosheet stack structures NSS.

Between a pair of source/drain regions SD arranged apart from each other in the second horizontal direction (the Y direction), a portion, which is a portion up to the second vertical level LV2 from a lowermost end, of the lower sheet separation wall LSWL of the sheet separation wall SWL may have a tapered shape where a horizontal width increases to be constant, and a portion, which is a portion up to an uppermost end (i.e., the fifth vertical level LV5) from the third vertical level LV3, of the upper sheet separation wall HSWL of the sheet separation wall SWL may have a tapered shape where a horizontal width increases to be constant. Also, a portion of the sheet separation wall SWL up to the third vertical level LV3 from the second vertical level LV2 may decrease in horizontal width to have a shape which is rounded convexly toward the outside. Between a pair of nanosheet stack structures NSS arranged apart from each other in the second horizontal direction (the Y direction), a portion of the lower sheet separation wall LSWL which is all portions up to an uppermost end (i.e., the fourth vertical level LV4) from a lowermost end may have a tapered shape where a horizontal width increases to be constant. The upper sheet separation wall HSWL may have a tapered shape where a horizontal width increases to be constant up to an uppermost end from a lowermost end. For example, at least a portion of the lower sheet separation wall LSWL may have a tapered shape where a width thereof in the second horizontal direction (the Y direction) increases away from a bottom surface of the base substrate layer BSUB, and at least a portion of each of the upper sheet separation walls HSWL may have a tapered shape where a width thereof in the first horizontal direction (the X direction) and/or the second horizontal direction (the Y direction) increases away from the bottom surface of the base substrate layer BSUB.

A pair of first contacts CA connected to a pair of source/drain regions SD which are arranged apart from each other in the second horizontal direction (the Y direction) with the sheet separation wall SWL therebetween may be apart from each other with the upper sheet separation wall HSWL, which is a portion of the sheet separation wall SWL, therebetween. That is, the sheet separation wall SWL may divide each of the nanosheet stack structure NSS and the source/drain region SD into a pair and may node-divide a pair of first contacts CA connected to a divided pair of source/drain regions SD. For example, a pair of gate electrodes GL may be on the pair of nanosheet stack structures NSS with the sheet separation wall SWL therebetween (e.g., see FIG. 12B). A first gate insulation layer Gox may between a first one of the pair of gate electrodes GL and a first one of the pair of nanosheet stack structures NSS, and a second gate insulation layer Gox may between a second one of the pair of gate electrodes GL and a second one of the pair of nanosheet stack structures NSS.

Referring to FIGS. 1 to 12D, the integrated circuit device 1 according to some embodiments may include the sheet separation wall SWL including the lower sheet separation wall LSWL which is formed before forming the dummy gate electrode DPCP and the upper sheet separation wall HSWL which is formed after the gate electrode GL is formed by an RMG process. Because the upper sheet separation wall HSWL is formed after the gate electrode GL is formed, skirt which is an undesired portion of the gate electrode GL may be prevented from occurring between the uppermost nanosheet semiconductor layer NS of the plurality of nanosheet semiconductor layers NS, the gate electrode GL, and the upper sheet separation wall HSWL and/or on an uppermost end of the upper sheet separation wall HSWL. Because the lower sheet separation wall LSWL is formed before forming the dummy gate electrode DPCP, a horizontal width of each of the plurality of nanosheet stack structures NSS and/or the source/drain region SD each divided into a pair by the lower sheet separation wall LSWL may be precisely adjusted in the second horizontal direction (the Y direction). Accordingly, an operation characteristic of the integrated circuit device 1 including a transistor including a multi-gate MOSFET may be enhanced.

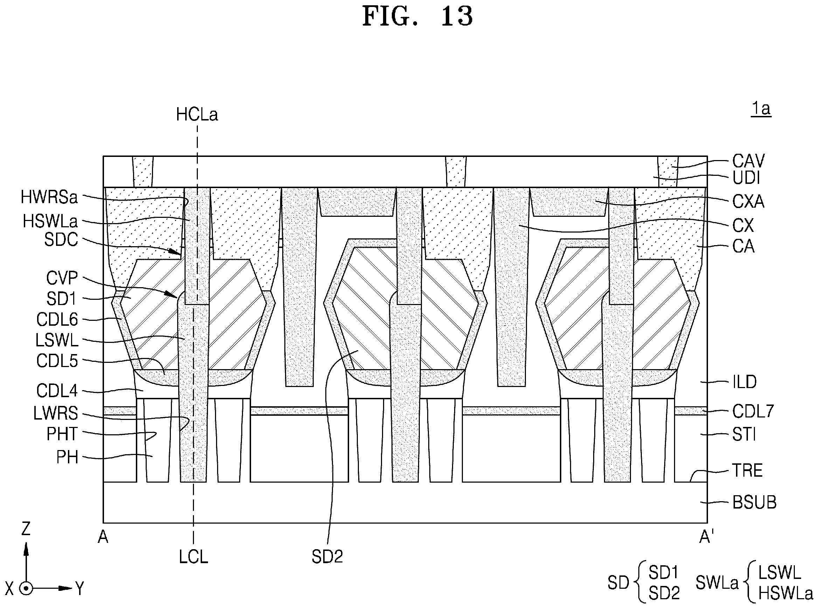

FIG. 13 is a vertical cross-sectional view of an integrated circuit device 1a according to some embodiments. In detail, FIG. 13 is a vertical cross-sectional view taken along a portion corresponding to line A-A' of FIG. 1.

Referring to FIG. 13, the integrated circuit device 1 a may include a plurality of sheet separation walls SWLa, instead of the plurality of sheet separation walls SWL included in the integrated circuit device 1 illustrated in FIGS. 12A to 12D. The plurality of sheet separation walls SWLa may include a plurality of upper sheet separation walls HSWLa and a plurality of lower sheet separation walls LSWL. In some embodiments, each of the plurality of sheet separation walls SWLa may include a lower sheet separation wall LSWL and upper sheet separation walls HSWLa disposed on the lower sheet separation wall LSWL. The lower sheet separation wall LSWL may fill a lower separation recess LWRS, and the upper sheet separation wall HSWLa may fill an upper separation recess HWRSa. In some embodiments, the lower sheet separation wall LSWL and the upper sheet separation walls HSWLa connected to each other may be configured as one body (e.g., may form one separation wall). With respect to the second horizontal direction (the Y direction), a center line LCL of the lower sheet separation wall LSWL and a center line HCLa of the upper sheet separation wall HSWLa may not be aligned with each other in a vertical direction (a Z direction). For example, with respect to a second horizontal direction (a Y direction), the center line HCLa of the upper sheet separation wall HSWLa may be shifted in the second horizontal direction (the Y direction) from the center line LCL of the lower sheet separation wall LSWL. In other words, a center point of the lower sheet separation wall LSWL in the second horizontal direction (the Y direction) and a center point of the upper sheet separation wall HSWLa in the second horizontal direction (the Y direction) may not be aligned with each other (i.e., may be offset from each other) along the vertical direction (the Z direction). As used herein, "an element A and an element B are offset from each other in a vertical direction" (or similar language) means that the element A and the element B are not aligned with each other along the vertical direction.

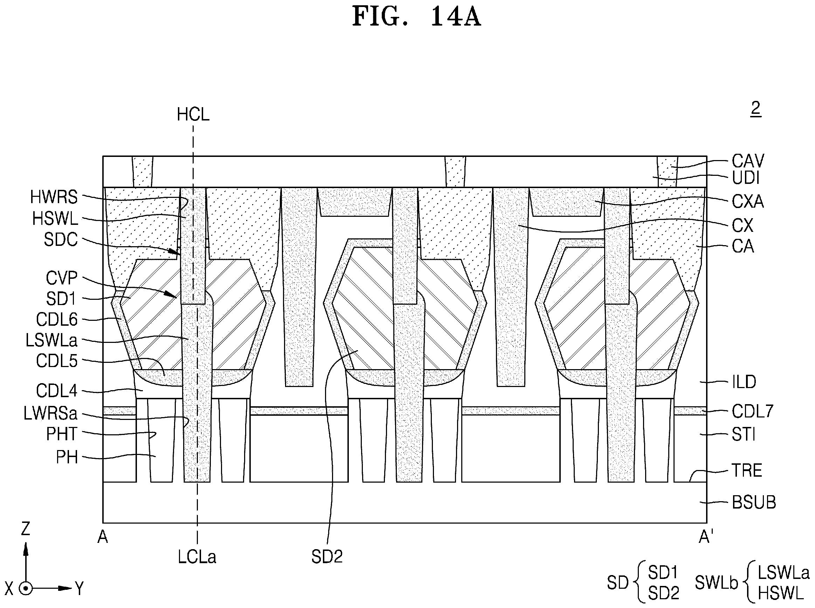

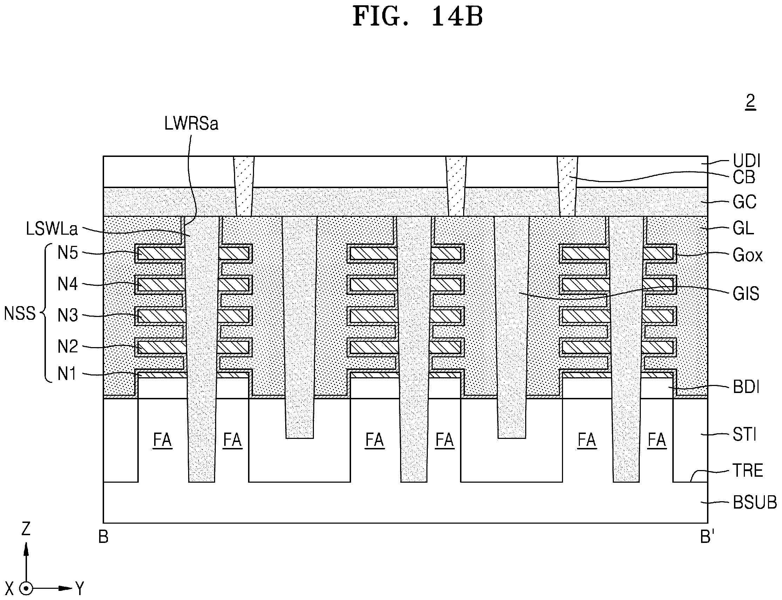

FIGS. 14A and 14B are vertical cross-sectional views of an integrated circuit device 2 according to some embodiments. In detail, FIGS. 14A and 14B are vertical cross-sectional views taken along portions corresponding to line A-A' and line B-B' of FIG. 1, respectively.

Referring to FIGS. 14A and 14B, the integrated circuit device 2 may include a plurality of sheet separation walls SWLb, instead of the plurality of sheet separation walls SWL included in the integrated circuit device 1 illustrated in FIGS. 12A to 12D. The plurality of sheet separation walls SWLb may include a plurality of upper sheet separation walls HSWL and a plurality of lower sheet separation walls LSWLa. In some embodiments, each of the plurality of sheet separation walls SWLb may include a lower sheet separation wall LSWLa and upper sheet separation walls HSWL disposed on the lower sheet separation wall LSWLa. The lower sheet separation wall LSWLa may fill a lower separation recess LWRSa, and the upper sheet separation wall HSWL may fill an upper separation recess HWRS. In some embodiments, the lower sheet separation wall LSWLa and the upper sheet separation walls HSWL connected to each other may be configured as one body (e.g., may form one separation wall). With respect to a second horizontal direction (a Y direction), a center line LCLa of the lower sheet separation wall LSWLa and a center line HCL of the upper sheet separation wall HSWL may not be aligned with each other in a vertical direction (a Z direction). For example, with respect to the second horizontal direction (the Y direction), the center line LCLa of the lower sheet separation wall LSWLa may be shifted in the second horizontal direction (the Y direction) from the center line HCL of the upper sheet separation wall HSWL. In other words, a center point of the lower sheet separation wall LSWLa in the second horizontal direction (the Y direction) and a center point of the upper sheet separation wall HSWL in the second horizontal direction (the Y direction) may not be aligned with each other along the vertical direction (the Z direction).

A horizontal width of each of a plurality of nanosheets N1 to N5 included in a nanosheet stack structure NSS, disposed at one side, of a corresponding pair of nanosheet stack structures NSS which are arranged apart from each other in the second horizontal direction (the Y direction) with the sheet separation wall SWLb therebetween and a horizontal width of each of a plurality of nanosheets N1 to N5 included in a nanosheet stack structure NSS disposed at the other side may differ. For example, in a case where the center line LCLa of the lower sheet separation wall LSWLa is shifted to the nanosheet stack structure NSS disposed at the other side from the center line HCL of the upper sheet separation wall HSWL, a horizontal width of each of the plurality of nanosheets N1 to N5 included in the nanosheet stack structure NSS disposed at the one side may be greater than a horizontal width of each of the plurality of nanosheets N1 to N5 included in the nanosheet stack structure NSS disposed at the other side.

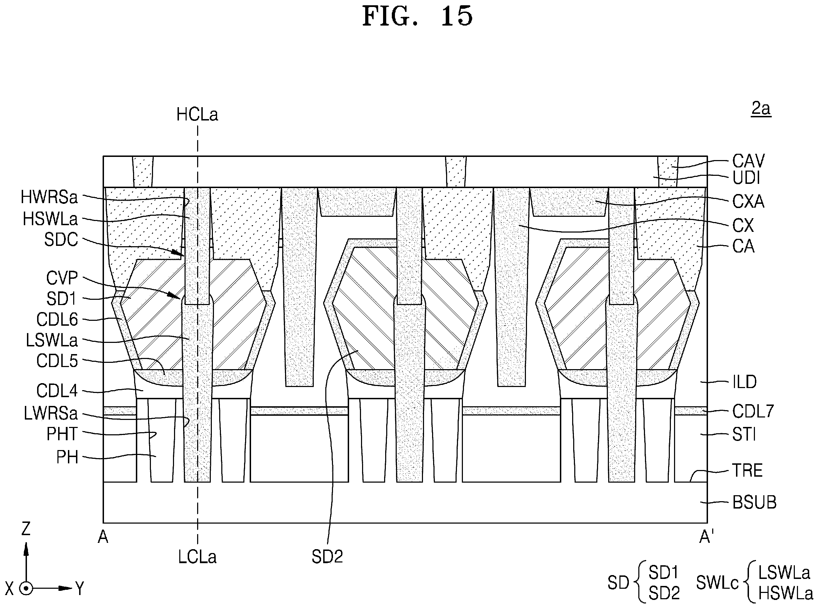

FIG. 15 is a vertical cross-sectional view of an integrated circuit device 2a according to some embodiments. In detail, FIG. 15 is a vertical cross-sectional view taken along a portion corresponding to line A-A' of FIG. 1.

Referring to FIG. 15, the integrated circuit device 2a may include a plurality of sheet separation walls SWLc, instead of the plurality of sheet separation walls SWL included in the integrated circuit device 1 illustrated in FIGS. 12A to 12D. The plurality of sheet separation walls SWLc may include a plurality of upper sheet separation walls HSWLa and a plurality of lower sheet separation walls LSWLa. In some embodiments, each of the plurality of sheet separation walls SWLc may include a lower sheet separation wall LSWLa and upper sheet separation walls HSWLa disposed on the lower sheet separation wall LSWLa. The lower sheet separation wall LSWLa may fill a lower separation recess LWRSa, and the upper sheet separation wall HSWLa may fill an upper separation recess HWRSa. In some embodiments, the lower sheet separation wall LSWLa and the upper sheet separation walls HSWLa connected to each other may be configured as one body (e.g., may form one separation wall). With respect to a second horizontal direction (a Y direction), a center line LCLa of the lower sheet separation wall LSWLa and a center line HCLa of the upper sheet separation wall HSWLa may be aligned with each other in a vertical direction (a Z direction). In other words, a center point of the lower sheet separation wall LSWLa in the second horizontal direction (the Y direction) and a center point of the upper sheet separation wall HSWLa in the second horizontal direction (the Y direction) may be aligned with each other along the vertical direction (the Z direction).

In the integrated circuit device 2a, like the plurality of nanosheet stack structures NSS each including the plurality of nanosheets N1 to N5 illustrated in FIG. 14B, a horizontal width of each of a plurality of nanosheets N1 to N5 included in a nanosheet stack structure NSS, disposed at one side, of a corresponding pair of nanosheet stack structures NSS which are arranged apart from each other in the second horizontal direction (the Y direction) with the sheet separation wall SWLc therebetween and a horizontal width of each of a plurality of nanosheets N1 to N5 included in a nanosheet stack structure NSS disposed at the other side may differ. For example, a horizontal width of each of a plurality of nanosheets N1 to N5 included in a nanosheet stack structure NSS, disposed at one side, of the sheet separation wall SWLc may be greater than a horizontal width of each of a plurality of nanosheets N1 to N5 included in a nanosheet stack structure NSS, disposed at the other side, of the sheet separation wall SWLc.

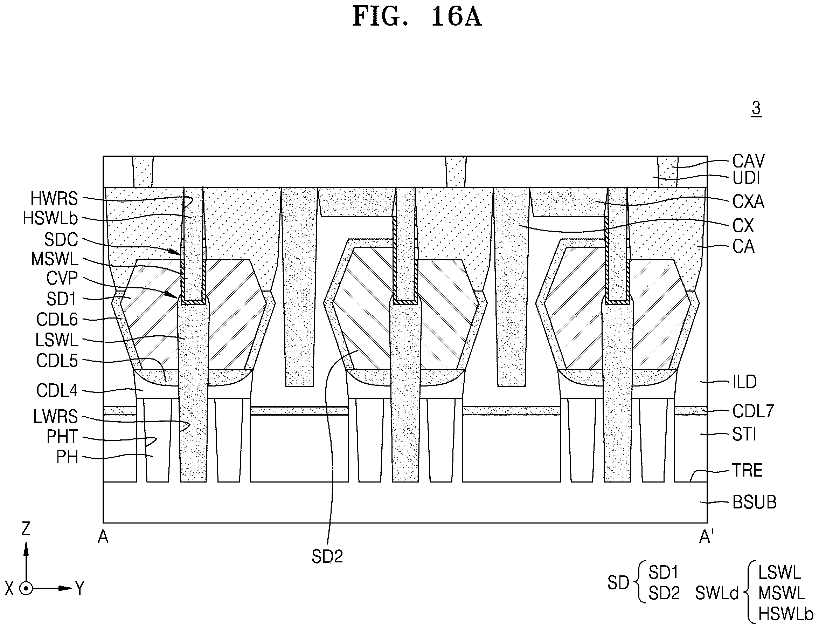

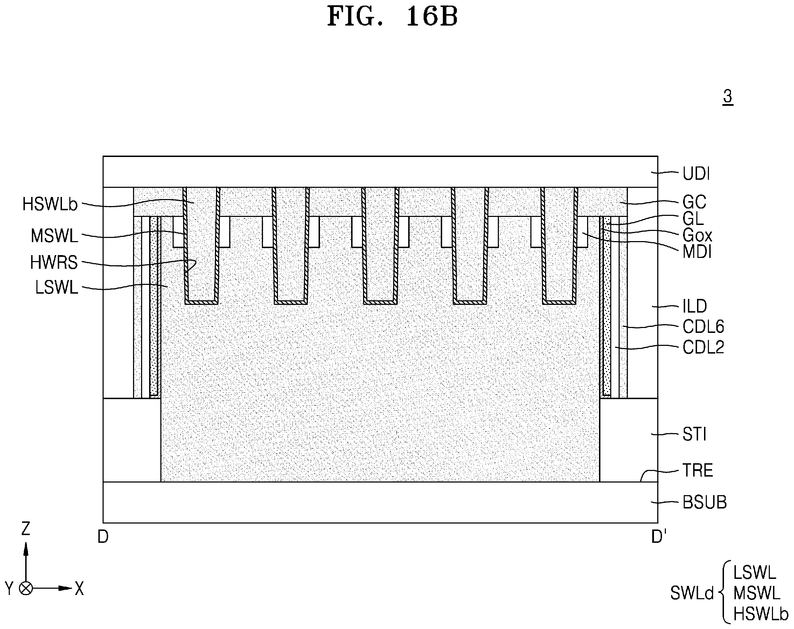

FIGS. 16A and 16B are vertical cross-sectional views of an integrated circuit device 3 according to some embodiments. In detail, FIGS. 16A and 16B are vertical cross-sectional views taken along portions corresponding to line A-A' and line D-D' of FIG. 1, respectively.

Referring to FIGS. 16A and 16B, the integrated circuit device 3 may include a plurality of sheet separation walls SWLd, instead of the plurality of sheet separation walls SWL included in the integrated circuit device 1 illustrated in FIGS. 12A to 12D. The plurality of sheet separation walls SWLd may include a plurality of lower sheet separation walls LSWL, a plurality of separation insulation layers MSWL, and a plurality of upper sheet separation walls HSWLb. In some embodiments, each of the plurality of sheet separation walls SWLd may include a lower sheet separation wall LSWL, upper sheet separation walls HSWLb disposed on the lower sheet separation wall LSWL, and separation insulation layers MSWL disposed between the lower sheet separation wall LSWL and the upper sheet separation walls HSWLb. The lower sheet separation wall LSWL may fill the lower separation recess LWRS, and the separation insulation layer MSWL and the upper sheet separation wall HSWLb may fill an upper separation recess HWRS.

The separation insulation layer MSWL may be on (e.g., may cover) a lower surface of the upper separation recess HWRS and may extend along an inner sidewall from a lower surface to be on (e.g., to cover) at least a portion of the inner sidewall. The upper sheet separation wall HSWLb may be on (e.g., may cover) the separation insulation layer MSWL and may fill the upper separation recess HWRS. The separation insulation layer MSWL may be disposed between the upper sheet separation wall HSWLb and each of the lower sheet separation wall LSWL, a source/drain region SD, a middle insulation layer MDI, and a gate capping layer GC and may separate the upper sheet separation wall HSWLb from each of the lower sheet separation wall LSWL, the source/drain region SD, the middle insulation layer MDI, and the gate capping layer GC. The separation insulation layer MSWL may be disposed between a first contact CA and the upper sheet separation wall HSWLb. In some embodiments, the separation insulation layer MSWL may be disposed at a portion between the first contact CA and the upper sheet separation wall HSWLb, but the separation insulation layer MSWL may not be disposed at the other portion between the first contact CA and the upper sheet separation wall HSWLb. For example, the separation insulation layer MSWL may be disposed at a lower partial portion between the first contact CA and the upper sheet separation wall HSWLb, but the separation insulation layer MSWL may not be disposed at an upper partial portion between the first contact CA and the upper sheet separation wall HSWLb. For example, upper portions of side surfaces of the first contact CA and the upper sheet separation wall HSWLb facing each other may contact each other, and the other portions may be apart from each other with the separation insulation layer MSWL therebetween.

Hereinabove, example embodiments have been described in the drawings and the specification. Embodiments have been described by using the terms described herein, but this has been merely used for describing the inventive concepts and has not been used for limiting a meaning or limiting the scope of the inventive concepts defined in the following claims. Therefore, it may be understood by those of ordinary skill in the art that various modifications and other equivalent embodiments may be implemented from the inventive concepts. Accordingly, the scope of the inventive concepts may be defined based on the scope of the following claims.

While the inventive concepts have been particularly shown and described with reference to example embodiments thereof, it will be understood that various changes in form and details may be made therein without departing from the scope of the following claims.

As used herein, the terms "comprises", "comprising", "includes", "including", "has", "having" and any other variations thereof specify the presence of the stated features, steps, operations, elements, components, and/or groups but do not preclude the presence or addition of one or more other features, steps, operations, elements, components, and/or groups thereof. In addition, it will be understood that, although the terms "first", "second", etc. may be used herein to describe various elements, these elements should not be limited by these terms. Rather, these terms are only used to distinguish one element from another. For example, a first element could be termed a second element, and, similarly, a second element could be termed a first element, without departing from the scope of the present disclosure.

## Claims

1. An integrated circuit device comprising:
a base substrate layer;
a sheet separation wall extending in a first horizontal direction on the base substrate layer;
a pair of nanosheet stack structures spaced apart from each other with the sheet separation wall therebetween in a second horizontal direction different from the first horizontal direction, the pair of nanosheet stack structures each including a plurality of nanosheets;
a pair of source/drain regions spaced apart from each other with the sheet separation wall therebetween in the second horizontal direction, wherein the pair of source/drain regions are electrically connected to the pair of nanosheet stack structures, respectively; and
a pair of gate electrodes extending in the second horizontal direction on the pair of nanosheet stack structures,
wherein opposing side surfaces of the sheet separation wall in the second horizontal direction comprise a round portion having a convex shape between the pair of source/drain regions.

2. The integrated circuit device of claim 1, wherein the opposing side surfaces of the sheet separation wall in the second horizontal direction are planar between the pair of nanosheet stack structures.

3. The integrated circuit device of claim 1 or claim 2, wherein the sheet separation wall extends between the pair of source/drain regions and into the base substrate layer, and
wherein the sheet separation wall extends between the pair of nanosheet stack structures and into the base substrate layer.

4. The integrated circuit device of any of claims 1 to 3, further comprising a gate capping layer on the pair of gate electrodes,
wherein an uppermost end of the sheet separation wall and an upper surface of the gate capping layer are coplanar with each other.

5. The integrated circuit device of any of claims 1 to 4, wherein the sheet separation wall comprises a lower sheet separation wall and upper sheet separation walls on the lower sheet separation wall.

6. The integrated circuit device of claim 5, wherein the lower sheet separation wall extends in the first horizontal direction, and
wherein the upper sheet separation walls are spaced apart from one another in the first horizontal direction.

7. The integrated circuit device of claim 5 or claim 6, wherein the upper sheet separation walls contact the lower sheet separation wall.

8. The integrated circuit device of claim 5 or claim 6, wherein the sheet separation wall further comprises separation insulation layers between the lower sheet separation wall and ones of the upper sheet separation walls, and the lower sheet separation wall and the ones of the upper sheet separation walls are separated from each other by the separation insulation layers.

9. The integrated circuit device of any of claims 5 to 8, wherein a center point of the lower sheet separation wall in the second horizontal direction and a center point of at least one of the upper sheet separation walls in the second horizontal direction are not aligned with each other along a vertical direction.

10. The integrated circuit device of any of claims 1 to 9, wherein a first width in the second horizontal direction of at least one of the plurality of nanosheets included in a first one of the pair of nanosheet stack structures is different from a second width in the second horizontal direction of at least one of the plurality of nanosheets included in a second one of the pair of nanosheet stack structures.

11. An integrated circuit device comprising:
a base substrate layer;
a sheet separation wall including a lower sheet separation wall extending in a first horizontal direction on the base substrate layer and upper sheet separation walls spaced apart from one another on the lower sheet separation wall;
a pair of nanosheet stack structures spaced apart from each other with the sheet separation wall therebetween in a second horizontal direction different from the first horizontal direction, the pair of nanosheet stack structures each including a plurality of nanosheets;
a pair of source/drain regions spaced apart from each other with the sheet separation wall therebetween in the second horizontal direction, wherein the pair of source/drain regions are electrically connected to the pair of nanosheet stack structures, respectively;
a pair of gate electrodes extending in the second horizontal direction on the pair of nanosheet stack structures;
a gate capping layer on the pair of gate electrodes;
a first gate insulation layer between a first one of the pair of gate electrodes and a first one of the pair of nanosheet stack structures; and
a second gate insulation layer between a second one of the pair of gate electrodes and a second one of the pair of nanosheet stack structures.

12. The integrated circuit device of claim 11, wherein opposing side surfaces of the sheet separation wall in the second horizontal direction comprise a round portion having a convex shape between the pair of source/drain regions, and
wherein the opposing side surfaces of the sheet separation wall are planar between the pair of nanosheet stack structures.

13. The integrated circuit device of claim 12, wherein the lower sheet separation wall extends into the base substrate layer, and a lowermost end of the lower sheet separation wall is closer to a bottom surface of the base substrate layer than a lowermost end of each of the pair of source/drain regions,
wherein a lowermost end of each of the upper sheet separation walls is farther from the bottom surface of the base substrate layer than the lowermost end of each of the pair of source/drain regions,
wherein an uppermost end of a portion of the lower sheet separation wall between the pair of source/drain regions is farther from the bottom surface of the base substrate layer than the lowermost end of each of the upper sheet separation walls,
wherein the lowermost end of each of the upper sheet separation walls is at a first vertical level from the bottom surface of the base substrate layer, and the uppermost end of the portion of the lower sheet separation wall between the pair of source/drain regions is at a second vertical level from the bottom surface of the base substrate layer, and
wherein the round portion is between the first vertical level and the second vertical level.

14. The integrated circuit device of claim 13, wherein an uppermost end of each of the pair of source/drain regions is closer to the bottom surface of the base substrate layer than an uppermost end of the lower sheet separation wall, and
wherein the uppermost end of each of the pair of source/drain regions contacts the sheet separation wall.

15. An integrated circuit device comprising:
a base substrate layer;
a sheet separation wall extending in a first horizontal direction and including a lower portion in the base substrate layer;
a pair of nanosheet stack structures spaced apart from each other with the sheet separation wall therebetween in a second horizontal direction different from the first horizontal direction, the pair of nanosheet stack structures each including a plurality of nanosheets;
a pair of source/drain regions spaced apart from each other with the sheet separation wall therebetween in the second horizontal direction, wherein the pair of source/drain regions are electrically connected to the pair of nanosheet stack structures, respectively;
a pair of gate electrodes extending in the second horizontal direction on the pair of nanosheet stack structures, wherein a first one of the pair of gate electrodes extends between adjacent ones of the plurality of nanosheets included in a first one of the pair of nanosheet stack structures, and wherein a second one of the pair of gate electrodes extends between adjacent ones of the plurality of nanosheets included in a second one of the pair of nanosheet stack structures;
a first gate insulation layer between the first one of the pair of gate electrodes and the first one of the pair of nanosheet stack structures;
a second gate insulation layer between the second one of the pair of gate electrodes and the second one of the pair of nanosheet stack structures;
a gate capping layer on the pair of gate electrodes;
an interlayer insulation layer on the pair of source/drain regions;
a first contact extending into the interlayer insulation layer and electrically connected to at least one of the pair of source/drain regions; and
a second contact extending into the gate capping layer and electrically connected to at least one of the pair of gate electrodes,
wherein the sheet separation wall comprises a lower sheet separation wall extending in the first horizontal direction and upper sheet separation walls spaced apart from one another on the lower sheet separation wall,
wherein opposing side surfaces of the sheet separation wall in the second horizontal direction comprise a round portion having a convex shape between the pair of source/drain regions, and
wherein the opposing side surfaces of the sheet separation wall are planar between the pair of nanosheet stack structures.
